(19)

Europäisches Patentamt
European Patent Office
Office européen des brevets

(11) **EP 1 950 795 A1**

(12) **EUROPEAN PATENT APPLICATION**
published in accordance with Art. 158(3) EPC

(43) Date of publication:
**30.07.2008 Bulletin 2008/31**

(51) Int Cl.:
***H01L 21/027*** (2006.01) ***G03F 7/20*** (2006.01)

(21) Application number: **06822680.2**

(86) International application number:
**PCT/JP2006/321751**

(22) Date of filing: **31.10.2006**

(87) International publication number:
**WO 2007/052659 (10.05.2007 Gazette 2007/19)**

(84) Designated Contracting States:
**AT BE BG CH CY CZ DE DK EE ES FI FR GB GR HU IE IS IT LI LT LU LV MC NL PL PT RO SE SI SK TR**

(30) Priority: **01.11.2005 JP 2005318139**

(71) Applicant: **Nikon Corporation**
**Tokyo 100-8331 (JP)**

(72) Inventor: **NAGASAKA, Hiroyuki**
**NIKON CORPORATION**
**Chiyoda-ku, Tokyo 1008331 (JP)**

(74) Representative: **Viering, Jentschura & Partner**
**Grillparzerstrasse 14**
**81675 München (DE)**

(54) **EXPOSURE APPARATUS, EXPOSURE METHOD AND DEVICE MANUFACTURING METHOD**

(57)     An exposure apparatus (EX) that irradiates exposure light (EL) onto a substrate (P) to expose the substrate, comprises an optical element (LS1) that has a concave surface (2) from which the exposure light is emitted, a supply port (12) that is provided on an object (4) that can be placed in opposition with the concave surface and that supplies a liquid to the space between the concave surface and the object, and a suction port (22) that is provided on the object and suctions the fluid of the space between the concave surface and the object.

FIG. 1

EP 1 950 795 A1

## Description

TECHNICAL FIELD

The present invention relates to an exposure apparatus that exposes a substrate, an exposure method and a device manufacturing method.

Priority is claimed on Japanese Patent Application No. 2005-318139 filed on November 1, 2005, the contents of which are incorporated herein by reference.

BACKGROUND ART

Known as an exposure apparatus used in photolithography processes is a liquid immersion type exposure apparatus that fills the optical path space of the exposure light with a liquid and exposes a substrate via that liquid, such as that disclosed in the following patent document.

PCT International Patent Publication No. WO 99/49504.

DISCLOSURE OF INVENTION

PROBLEMS TO BE SOLVED BY THE INVENTION

In a liquid immersion type exposure apparatus, when gas (including bubbles) is present in the liquid arranged in the optical path space of the exposure light, there is a possibility that exposure defects will occur.

A purpose of the present invention is to provide an exposure apparatus that is able to fill the optical path space of the exposure light with a liquid, an exposure method, and a device manufacturing method that uses that exposure apparatus.

MEANS FOR SOLVING THE PROBLEM

The present invention employs the following configurations summarized below in conjunction with the drawings that illustrate embodiments. In this regard, reference numerals in parentheses are attached to individual elements merely for the purpose of illustration and are not intended to limit the respective elements.

According to a first aspect of the present invention, an exposure apparatus is provided that irradiates exposure light onto a substrate to expose the substrate; wherein it comprises an optical element that has a concave surface from which the exposure light is emitted, a supply port that is provided on an object and that can be placed in opposition with the concave surface and supplies the liquid to the space between the concave surface and the object, and a suction port that is provided on the object and suctions fluid between the concave surface and the object.

According to a second aspect of the present invention, an exposure apparatus is provided that irradiates exposure light onto a substrate to expose the substrate; wherein it comprises an optical element that has a concave surface from which the exposure light is emitted, an object that includes a convex surface, and a supply port that supplies the liquid to the space between the concave surface and the convex surface in a status in which the concave surface and the convex surface have been placed in opposition.

According to a third aspect of the present invention, an exposure method is provided that irradiates exposure light onto a substrate via an optical element to expose the substrate; wherein it includes supply of a liquid from a supply port provided on an object that can be placed in opposition with the concave surface of the optical element to the space between the concave surface and the object and suction of fluid between the concave surface and the object from a suction port provided on that object.

According to a fourth aspect of the present invention, an exposure method is provided that irradiates exposure light onto a substrate via an optical element to expose the substrate; wherein it includes arrangement of an object in opposition with the concave surface of the optical element and supply of a liquid to the space between the concave surface and the object, and the liquid flows along the concave surface.

According to a fifth aspect of the present invention, an exposure method is provided that irradiates exposure light onto a substrate via an optical element to expose the substrate; wherein it includes arrangement of an object in opposition with the concave surface of the optical element and supply of a liquid to the space between the concave surface and the object, and supply of the liquid is performed from the concave surface side with respect to the object.

According to a sixth aspect of the present invention, an exposure method is provided that irradiates exposure light onto a substrate via an optical element to expose the substrate; wherein it includes arrangement of an object in opposition with the concave surface of the optical element and supply of a liquid to the space between the concave surface and the object, and it differentiates the liquid supply path used when the liquid is filled into the space and the liquid supply path used at the time of the substrate exposure.

According to a seventh aspect of the present invention, an exposure method is provided that irradiates exposure light onto a substrate via an optical element to expose the substrate; wherein it includes supply of a liquid to the space between the light emittance surface of the optical element and an object and changing of the interval of the optical element and the object in the time from the start of supply of the liquid until the space is filled with the liquid.

According to an eighth aspect of the present invention, a device manufacturing method that uses the above exposure method is provided.

EFFECTS OF THE INVENTION

Through the present invention, it is possible to fill a prescribed portion of the optical path of the exposure light with a liquid, and it is possible to expose the substrate well.

BRIEF DESCRIPTION OF THE DRAWINGS

FIG. 1 is a schematic block diagram that shows an exposure apparatus relating to the first embodiment.
FIG. 2A is a drawing that shows a liquid immersion system relating to the first embodiment.
FIG. 2B is a drawing that shows a liquid immersion system relating to the first embodiment.
FIG 3 is a drawing for explaining the operation of an exposure apparatus relating to the first embodiment.
FIG. 4A is a drawing for explaining the operation of an exposure apparatus relating to the first embodiment.
FIG. 4B is a drawing for explaining the operation of an exposure apparatus relating to the first embodiment.
FIG. 5A is a drawing for explaining the operation of an exposure apparatus relating to the first embodiment.
FIG. 5B is a drawing for explaining the operation of an exposure apparatus relating to the first embodiment.
FIG. 6 is a drawing for explaining the operation of an exposure apparatus relating to the first embodiment
FIG. 7 is a drawing for explaining the operation of an exposure apparatus relating to the first embodiment.
FIG. 8A is a drawing for explaining the principals of a detection apparatus relating to the first embodiment.
FIG. 8B is a drawing for explaining the principals of a detection apparatus relating to the first embodiment.
FIG. 9 is a drawing that shows the principal parts of an exposure apparatus relating to the second embodiment.
FIG. 10 is a drawing that shows the principal parts of an exposure apparatus relating to the third embodiment.
FIG. 11A is a drawing that shows the principal parts of an exposure apparatus relating to the fourth embodiment.
FIG. 11B is a drawing that shows the principal parts of an exposure apparatus relating to the fourth embodiment.
FIG. 12A is a drawing for explaining the operation of an exposure apparatus relating to the fourth embodiment.
FIG. 12B is a drawing for explaining the operation of an exposure apparatus relating to the fourth embodiment.

FIG. 13A is a drawing for explaining the operation of an exposure apparatus relating to the fourth embodiment.
FIG. 13B is a drawing for explaining the operation of an exposure apparatus relating to the fourth embodiment.
FIG. 14 is a drawing that shows the principal parts of an exposure apparatus relating to the fifth embodiment.
FIG. 15 is a drawing that shows the principal parts of an exposure apparatus relating to the sixth embodiment.
FIG. 16 is a drawing that shows the principal parts of an exposure apparatus relating to the seventh embodiment.
FIG. 17 is a drawing for explaining the operation of an exposure apparatus relating to the seventh embodiment.
FIG. 18 is a drawing that shows the principal parts of an exposure apparatus relating to the eighth embodiment.
FIG. 19 is a drawing that shows the principal parts of an exposure apparatus relating to the ninth embodiment.
FIG. 20 is a drawing that shows the principal parts of an exposure apparatus relating to the tenth embodiment.
FIG. 21A is a drawing for explaining the operation of an exposure apparatus relating to the tenth embodiment.
FIG. 21B is a drawing for explaining the operation of an exposure apparatus relating to the tenth embodiment.
FIG. 22A is a drawing for explaining the operation of an exposure apparatus relating to the tenth embodiment.
FIG. 22B is a drawing for explaining the operation of an exposure apparatus relating to the tenth embodiment.
FIG. 23 is a drawing that shows the principal parts of an exposure apparatus relating to the eleventh embodiment.
FIG. 24 is a drawing for explaining the operation of an exposure apparatus relating to the eleventh embodiment.
FIG. 25 is a flow chart for explaining an example of a microdevice fabrication process.

DESCRIPTION OF THE REFERENCE SYMBOLS

1: LIQUID IMMERSION SYSTEM, 2: CONCAVE SURFACE, 4: SUBSTRATE STAGE, 4F: UPPER SURFACE, 4T: SUBSTRATE TABLE, 5: MEASURING STAGE, 7: CONTROL APPARATUS, 12: SUPPLY PORT, 22: SUCTION PORT, 23: SECOND SUCTION PORT, 30: DETECTION APPARATUS, 40: CONCAVE PART, 54: DRIVE APPARATUS, 64: DRIVE APPARATUS, 70: PRESCRIBED MEMBER, 71: CONVEX SURFACE, 82: SUPPLY PORT, 84: RECOVERY PORT, AX: OPTICAL AXIS, EL: EXPOSURE LIGHT, EX: EXPOSURE APPARATUS, K: OPTICAL PATH, LG: EDGE, LQ: LIQUID, LR: LIQUID IMMERSION REGION, LS1: FINAL OPTICAL ELEMENT, P: SUBSTRATE, PK: LENS BARREL, PKA: LOWER SURFACE, PL: PROJECTION OPTICAL SYSTEM, SP: PRESCRIBED SPACE

BEST MODE FOR CARRYING OUT THE INVENTION

Embodiments of the present invention will be explained below while referring to drawings, but the present invention is not limited to these. Note that, in the explanation below, an XYZ rectangular coordinate system will be set up, and the positional relationships of the respective members will be explained while referring to this XYZ rectangular coordinate system. Then, a prescribed direction within the horizontal plane is set as the X axis direction, a direction perpendicular to the X axis direction within the horizontal plane is set as the Y axis direction, and a direction perpendicular to the X axis direction and the Y axis direction respectively (that is, the vertical direction) is set as the Z axis direction. In addition, the directions of rotation (inclination) about the X axis, Y axis and the Z axis are respectively set as the $\theta X$, $\theta Y$ and $\theta Z$ directions.

<First Embodiment>

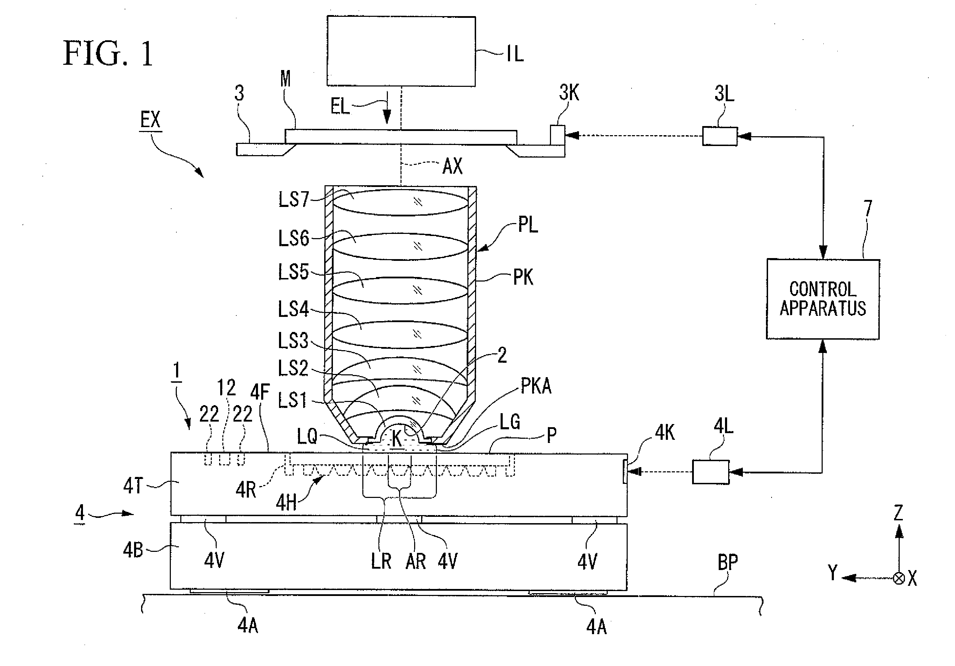

The first embodiment will be explained. FIG. 1 is a schematic block diagram that shows an exposure apparatus EX relating to the first embodiment. In FIG. 1, the exposure apparatus EX comprises a mask stage 3 that holds a mask M and is movable, a substrate stage 4 that holds a substrate P and is movable, an illumination system IL that illuminates a mask M held by the mask stage 3 using exposure light EL, a projection optical system PL the projects the pattern image of the mask M illuminated by the exposure light EL onto the substrate P, and a control apparatus 7 that controls the operation of the entire exposure apparatus EX.

Note that the substrate discussed here includes those in which a film such as a photosensitive material (photoresist), a protective film, etc. has been coated onto a base material such as a semiconductor wafer. The mask includes a reticle on which a device pattern that has been reduction projected onto the substrate has been formed. In addition, in the present embodiment, a transmission type mask is used as the mask, but a reflection type mask may also be used.

The exposure apparatus EX of the present embodiment is a liquid immersion type exposure apparatus that has applied a liquid immersion method that effectively shortens the exposure wavelength to improve resolution and effectively broaden the depth of focus, and the exposure light EL is irradiated onto the substrate P via the projection optical system PL and the liquid LQ to expose the substrate P. In the present embodiment, the liquid LQ is filled between the final optical element LS1, which is nearest the image plane of the projection optical system PL from among the plurality of optical elements LS1 to LS7 of the projection optical system PL, and the substrate P. In addition, in the present embodiment, the final optical element LS 1 has a concave surface 2 from which the exposure light EL is emitted.

The exposure apparatus EX comprises a concave surface 2 from which the exposure light EL of the final optical element LS 1 is emitted and a liquid immersion system 1 for filling a prescribed space between that concave surface 2 and an opposing object with a liquid LQ. The liquid immersion system 1 comprises a supply port 12, which is provided on a substrate stage 4 that can be placed in opposition with a concave surface 2 of the final optical element LS 1 and supplies the liquid LQ between the concave surface 2 and the substrate stage 4, and a suction port 22, which is provided on the substrate stage 4 and suctions the fluid between the concave surface 2 and the substrate stage 4. As discussed below, when the substrate P is exposed, the control apparatus 7 moves the substrate stage 4 with respect to the projection optical system PL and the liquid LQ in the prescribed direction within the XY plane so that the projection optical system PL and the substrate P oppose each other after the space between the concave surface 2 and the substrate stage 4 has been filled with the liquid LQ using a liquid immersion system 1 and uses the liquid LQ to fill a prescribed space that includes the optical path K of the exposure light EL between the concave surface 2 of the final optical element LS1 and the surface of the substrate P held by the substrate stage 4. The exposure surface of the substrate P is an exposure surface that has been coated with a photosensitive material. The concave surface 2 and the surface of the substrate P come into contact with the liquid LQ that fills the optical path K.

The exposure apparatus EX fills a prescribed space, which includes the optical path K of the exposure light EL between the concave surface 2 of the final optical element LS 1 and the surface of the substrate P, with the liquid LQ at least while the projection optical system PL is being used to project the pattern image of the mask M onto the substrate P. The exposure apparatus EX exposes the substrate P by projecting the pattern image of the mask M onto the substrate P by irradiating exposure light EL that has passed through the mask M via the projection optical system PL and the liquid LQ that fills the optical path K of the exposure light EL onto the substrate P held on the substrate stage 4. In addition, the exposure apparatus EX of the present embodiment employs a local liquid immersion system such that the liquid LQ that has been filled into the optical path K of the exposure light EL between the final optical element LS1 and the substrate P locally forms a liquid immersion region LR that is larger than the projection region AR and smaller than the substrate P in a region of a portion on the substrate P that includes the projection region AR of the projection optical system PL.

In the present embodiment, the optical axis AX of the projection optical system PL and the Z axis direction are parallel. In addition, the plurality of optical elements LS1 to LS7 of the projection optical system PL is held by a lens barrel PK. The lens barrel PK has a lower surface PKA provided so that it is in opposition with the surface of the substrate P arranged at a position where the exposure light EL can be irradiated, specifically, at a position that is in opposition with the concave surface 2, and so that it surrounds the optical path K of the exposure light EL. The lower surface PKA is formed so that it surrounds the concave surface 2. When the optical path K of the exposure light EL between the concave surface 2 and the surface of the substrate P is filled with the liquid LQ to form the liquid immersion region LR, an interface LG of the liquid LQ that forms the liquid immersion region LR is maintained between the surface of the substrate P and the lower surface PKA of the lens barrel PK by means of the surface tension of the liquid LQ. The exposure apparatus EX irradiates the exposure light EL onto the substrate P via the projection optical system PL, which includes the final optical element LS1, and the liquid LQ that fills the space between the concave surface 2 of the final optical element LS1 and the surface of the substrate P.

The illumination system IL illuminates a prescribed illumination region on the mask M using exposure light EL with a uniform illumination intensity distribution. For the exposure light EL that is emitted from the illumination system IL, for example, deep ultraviolet light (DUV light) such as bright lines (g-rays, h-rays, i-rays) that are emitted from a mercury lamp and KrF excimer laser light (wavelength of 248 nm) or vacuum ultraviolet light (VUV light) such as ArF excimer laser light (wavelength of 193 nm) and $F_2$ laser light (wavelength of 157 nm) are used. In the present embodiment, ArF excimer laser light is used as the exposure light EL.

The mask stage 3 is able to move in the X axis, Y axis and θZ axis direction in a status in which the mask M is held through the driving of a mask stage drive apparatus that includes an actuator such as a linear motor. Position information of the mask stage 3 (and, in turn, the mask M) is measured by a laser interferometer 3L. The laser interferometer 3L measures position information of the mask stage 3 using a movable mirror 3K provided on the mask stage 3. The control apparatus 7 drives a mask stage drive apparatus 3D based on the measurement results of the laser interferometer 3L and performs positional control of the mask M held on the mask stage 3.

Note that the movable mirror 3K may be one that includes not only a flat mirror but a corner cube (retroreflector), and a reflecting surface formed, for example, by mirror finishing the end face (side surface) of the mask stage 3 instead of securing the movable mirror 3K to the mask stage 3 may also be used. In addition, the mask stage 3 may have a configuration that is capable of rough and fine movement disclosed in, for example, Japanese Unexamined Patent Application Publication No. H8-130179 (corresponds to U.S. Patent No. 6,721,034).

The substrate stage 4 comprises a stage main body 4B, a substrate table 4T that has been mounted onto the stage main body 4B, and a substrate holder 4H that is provided on the substrate table 4T and holds the substrate P. The substrate holder 4H is arranged in a concave part 4R provided on the substrate table 4T, and the upper surface 4F surrounding the concave part 4R of the substrate table 4T is a flat surface such that it becomes nearly the same height (flush) as the surface of the substrate P held by the substrate holder 4H. Note that there may be a level difference between the surface of the substrate P held on the substrate holder 4H and the upper surface 4F of the substrate table 4T. In addition, the upper surface 4F of the substrate stage 4 is such that a portion thereof may be nearly the same height as the surface of the substrate P only in a prescribed range that surrounds the substrate P, for example. In addition, the substrate holder 4H may be formed as a unit with a portion of the substrate stage 4, but in the present embodiment, the substrate holder 4H and the substrate stage 4 are separately configured, and, for example, the substrate holder 4H is secured to the concave part 4R by vacuum suction attachment, etc.

The stage main body 4B is supported without contact with respect to the upper surface (guide surface) of the base member BP by means of air bearings 4A. The upper surface of the base member BP is nearly parallel to the XY plane, and the substrate stage 4 is able to move in the XY direction within a prescribed region on the base member BP that includes a position that opposes the concave surface 2 of the final optical element LS1.

The substrate stage 4, through the driving of the substrate stage drive apparatus, which includes an actuator such as a linear motor, is able to move on the base member BP in a status in which the substrate P is held on the substrate holder 4H. The substrate stage drive apparatus comprises a first drive system, which, by moving the stage main body 4B in the X axis direction, the Y axis direction and the θZ direction on the base member BP, is able to move the substrate table 4T that is mounted onto the stage main body 4B in the X axis direction, the Y axis direction and the θZ direction, and a second drive system, which is able to move the substrate table 4T with respect to the stage main unit 4B in the Z axis direction, the θX direction and the θY direction.

The first drive system includes an actuator such as a linear motor and is able to drive the stage main body 4B, which is supported without contact on the base member BP, in the X axis direction, the Y axis direction and the θZ direction. The second drive system includes actuators 4V such as a voice coil motor, for example, interposed between the stage main body 4B and the substrate table 4T and a measuring apparatus (encoder, etc.) that is not shown in the drawing and that measures the drive amounts of the respective actuators. The substrate table 4T is supported on the stage main body 4B by means of at least three actuators 4V. The respective actuators 4V are able to independently drive the substrate table 4T in the Z axis direction with respect to the stage main body 4B, and the control apparatus 7 drives the substrate table 4T in the Z axis direction, the θX direction and the θY direction with respect to the stage main body 4B by adjusting the respective drive amounts of the three actuators. In this way, the substrate stage drive apparatus, which includes the first and second drive systems, is able to move the substrate table 4T of the substrate stage 4 in directions with six degrees of freedom, which are the X axis, Y axis, Z axis, θX, θY and θZ directions. The control apparatus 7 is able to control the position of the surface of the substrate P held on the substrate holder 4H of the substrate table 4T relating to directions with six degrees of freedom, which are the X axis, Y axis, Z axis, θX, θY and θZ directions, by controlling the substrate stage drive apparatus.

Position information of the substrate table 4T of the substrate stage 4 (and, in turn, substrate P) is measured by a laser interferometer 4L. The laser interferometer 4L uses a movable mirror 4K provided on the substrate table 4T to measure position information of the substrate table 4T relating to the X axis, Y axis and θZ directions. In addition, the surface position information of the surface of the substrate P held by the substrate holder 4H of the substrate table 4T (position information relating to the Z axis, θX and θY directions) is detected by a focus / leveling detection system that is not shown in the drawing. The control apparatus 7 drives the substrate stage drive apparatus and performs positional control of the substrate P held by the substrate holder 4H based on the measurement results of the laser interferometer 4L and the detection results of the focus / leveling detection system.

Note that the laser interferometer 4L may be such that it is able to measure both the position in the Z axis direction and the θX and θY direction rotation information of the substrate stage 4, and details thereof are disclosed in, for example, Published Japanese translation No. 2001-510577 of PCT International Application (corresponds to International Publication No. WO 1999/28790). In addition, instead of securing a movable mirror 4K on the substrate stage 4, for example, a reflecting surface formed by mirror processing a portion (such as the side surface) of the substrate stage 4 may also be used.

In addition, the focus / leveling detection system is one which detects inclination information (rotation angle) of the substrate P in the θX and θY directions by measuring the respective position information of the substrate P in the Z axis direction at a plurality of measuring points thereof, but this plurality of measuring points is such that at least a portion thereof may be set within the liquid immersion region LR (or the projection region AR), or all of them may be set outside the liquid immersion region LR. In addition, for example, when the laser interferometer 4L is able to measure position information of the substrate P in the Z axis, θX and θY directions, the focus / leveling detection system need not be provided so that, during the exposure operation of the substrate P, it becomes possible to measure the Z axis direction position information thereof, and, at least during the exposure operation, the measurement results of the laser interferometer 4L may be used to perform positional control of the substrate P relating to the Z axis, θX and θY directions.

Note that the projection optical system PL of the present embodiment is a reduction system whose projection magnification is, for example, 1/4, 1/5, 1/8, etc., and a reduced image of the mask pattern is formed in a projection region AR that is conjugate with the aforementioned illumination region. Note that the projection optical system PL may be any of a reduction system, a magnification system or an enlargement system. In addition, the projection optical system PL may also be any of a refracting system that does not include a reflecting optical element, a reflecting system that does not include a refracting optical element, or a catadioptric system that includes both a reflecting optical element and a refracting optical element. In addition, the projection optical system PL may form either an inverted image or an erect image.

Next, the liquid LQ and the final optical element LS 1 will be explained. In the following explanation, for simplicity, the refractive index of the liquid LQ with respect to the exposure light EL is to be called the refractive index of the liquid LQ as appropriate, and the refractive index of the final optical element LS 1 with respect to the exposure light EL is to be called the refractive index of the final optical element LS 1 as appropriate.

In the present embodiment, the refractive index of the liquid LQ with respect to the exposure light EL (ArF excimer laser light: 193 nm wavelength) is higher than the refractive index of the final optical element LS 1 with respect to the exposure light EL, and the optical path K is filled with the liquid LQ, which has a higher refractive index than the refractive index of the final optical element LS 1. For example, in the case where the final optical element LS 1 is formed of quartz, the refractive index of the quartz is approximately 1.5, so a liquid LQ whose refractive index is higher than the refractive index of the quartz, for example, approximately 1.6 to 2.0, is used.

The optical path of the +Z side (object plane side, mask side) of the final optical element LS 1 is filled with a gas (for example, nitrogen), and the optical path of the -Z side (image plane side, substrate side) of the final optical element LS1 is filled with the liquid LQ. The shape of the surface (hereunder, referred to as the first surface) of the +Z side (object plane side) of the final optical element LS1 is a convex curved surface shape that swells toward the object plane side (mask side) of the projection optical system PL, and it is a shape such that all of the light rays to undergo image formation on the surface (image plane) of the substrate P will be incident.

The shape of the surface (hereunder, referred to as the second surface) of the -Z side (image plane side) of the final optical element LS1 is a concave surface 2 that is sunken in so that it separates from the substrate P. Specifically, the second surface (concave surface 2) of the final optical element LS1 is also a convex curved surface shape facing the image plane side (mask side). In addition, the shape of the second surface (concave surface 2), in the same way as the shape of the first surface, is such that all of the light rays to undergo image formation on the surface of the substrate P will be incident.

The curved surface shapes of the first surface and the second surface of the final optical element LS 1 may be appropriately determined so that the projection optical system PL achieves the desired performance, and the respective first surface and second surface may be spherical shapes that have the same center of curvature, spherical shapes that have different centers of curvature, or aspheric shapes.

The numerical aperture NA of the image plane side of the projection optical system PL is expressed by the following equation.

$$NA = n \cdot \sin\theta \quad ...(1)$$

Here, n is the refractive index of the liquid LQ, and $\theta$ is the convergence half angle. Also, the resolution Ra and the depth of focus $\delta$ are respectively expressed by the following equations.

$$Ra = k_1 \cdot \lambda/NA \quad ...(2)$$

$$\delta = \pm k_2 \cdot \lambda/NA^2 \quad ...(3)$$

Here, $\lambda$ is the exposure wavelength, and $k_1$ and $k_2$ are process coefficients. In this way, based on Equation (2) and Equation (3), it is possible to greatly improve the resolution and the depth of focus by multiplying the numerical aperture NA by approximately n times by means of a liquid LQ that has a higher refractive index (n).

In the case where an attempt has been made to obtain an numerical aperture NA of the projection optical system PL equal to or larger than the refractive index of the final optical element LS1, when the second surface, which is in opposition with substrate P of the final optical element LS1, is a flat surface that is nearly perpendicular with the optical axis AX, a portion of the exposure light EL is completely reflected by the interface of the final optical element LS1 and that the liquid LQ (that is, the second surface) and is unable to reach the image plane of the projection optical system PL. For example, when the refractive index of the final optical element LS 1 is $n_1$, the refractive index of the liquid LQ is $n_2$, the angle of the outermost light ray of the exposure light EL incident to the interface (second surface) of the final optical element LS1 and the liquid LQ with respect to the optical axis is $\theta_1$, and the angle of the outermost light ray that is emitted from that interface (incident to the liquid LQ) with respect to the optical axis AX is $\theta_2$, the following equation is established by Snell's law.

$$n_1\sin\theta_1 = n_2\sin\theta_2 \quad ...(4)$$

In addition, the numerical aperture NA of the projection optical system PL is expressed by the following equation when using the refractive index $n_2$ of the liquid LQ and the angle $\theta_2$ of the outermost light ray incident to the liquid LQ with respect to the optical axis AX.

$$NA = n_2\sin\theta_2 \quad ...(5)$$

The following equation is established by Equations (4) and (5).

$$\sin\theta_1 = NA/n_1 \quad ...(6)$$

Therefore, as is clear from Equation (6), in the case where the interface (second surface) of the final optical element LS1 and the liquid LQ is a flat surface that is nearly perpendicular to the optical axis AX, and the numerical aperture NA of the projection optical system PL is larger than the refractive index $n_1$ of the final optical element LS1, a portion of the exposure light EL cannot enter the liquid LQ. In contrast with this, the second surface of the final optical element LS1 of the present embodiment has a concave surface 2, so even if the numerical aperture NA of the projection optical system PL is larger than the refractive index $n_1$ of the final optical element LS1, the angle of incidence of the light ray incident to be interface of the final optical element LS 1 and the liquid LQ is small, so the outermost light ray of the exposure light EL is also able to reach the image plane well.

In this way, in the case where the refractive index of the liquid LQ with respect to the exposure light EL is higher than the refractive index of the final optical element LS 1 with respect to the exposure light EL, and the numerical aperture NA of the projection optical system PL is larger than the refractive index of the final optical element LS1 with respect to the exposure light EL, it is possible to cause the exposure light EL to reach onto the substrate P well by providing a concave surface 2 on the final optical element LS1.

Examples of the liquid LQ are a prescribed liquid that has a C-H bond and/or an O-H bond, such as isopropanol with a refractive index of approximately 1.50 and glycerol (glycerin) with the refractive index of approximately 1.61, a prescribed liquid (organic solvent) such as hexane, heptane or decane, or a prescribed liquid such as decalin, bicyclohexyl, etc. Or, it may be one in which any two or more types of liquid from among these prescribed liquids are mixed, and it may be one in which the above prescribed liquids are added to (mixed with) pure water. Or, the liquid LQ may be one in which a base or acid, such as $H^+$, $Cs^+$, $K^+$, $Cl^-$, $SO_4^{2-}$ or $PO_4^{2-}$, is added to pure water. In addition, it may be one in which particles such as Al oxide, etc. are added to (mixed with) pure water. These liquids LQ are such that they are able to transmit ArF excimer laser light. In addition, it is preferable that the liquid LQ have a small light absorption coefficient, a small temperature dependency, and be stable with respect to the projection optical system PL and/or the photosensitive material coated onto the surface of the substrate P.

In addition, the final optical element LS 1 can be formed by quartz (silica) for example. Or, it may be formed of calcium fluoride (fluorite), barium fluoride, strontium fluoride, lithium fluoride, sodium fluoride, or fluoride compound monocrystalline materials such as $BALiF_3$. In addition, the final optical element LS1 may also be formed of a lutetium aluminum garnet (LuAG). In addition, optical elements LS2 to LS7 may be formed by the aforementioned materials. Or, for example, optical elements LS2 to LS7 may be formed by fluorite, optical element LS1 may be formed by quartz, optical elements LS2 to LS7 may be formed by quartz, and optical element LS 1 may be formed by fluorite, or all of optical elements LS1 to LS5 may be formed by quartz (or fluorite).

In addition, for the optical elements of the projection optical system PL, which include the final optical element LS1, the final optical element LS 1 may be formed by a material with a higher refractive index than that of quartz and/or fluorite (for example, 1.6 or higher). For example, it is possible to form the optical elements of the projection optical system using sapphire, germanium dioxide, etc., such as that disclosed in PCT International Patent Publication No. WO 2005/059617. Or, it is possible to form the optical elements of the projection optical system using potassium chloride (refractive index of approximately 1.75), such as that disclosed in PCT International Patent Publication No. WO 2005/059618.

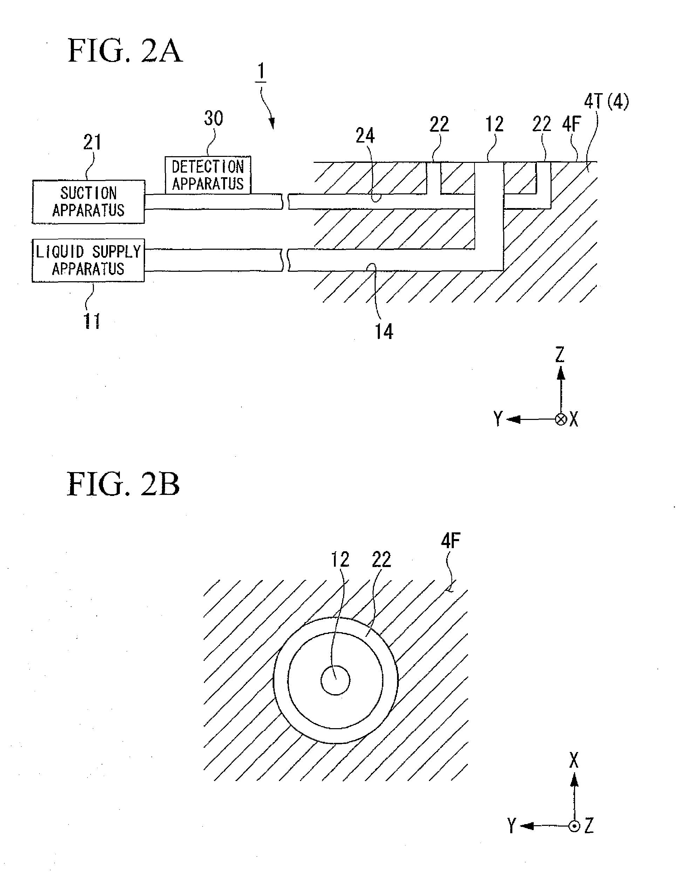

FIG. 2A and FIG. 2B show a liquid immersion system 1, where FIG. 2A is a side cross-sectional view, and FIG. 2B is a plan view as seen from above. In FIG. 2A and FIG. 2B, the liquid immersion system 1 comprises a suction port 12, which is provided on the upper surface 4F of the substrate table 4T (substrate stage 4), which can be placed in opposition with the concave surface 2 of the final optical element LS 1, and which supplies the liquid LQ between the concave surface 2 and the substrate table 4T, a suction port 22, which is provided at the upper surface 4F of the substrate table 4T and which suctions the fluid (including the liquid LQ and gas GS) between the concave surface 2 and the substrate table 4T, a liquid supply apparatus 11, which supplies the liquid LQ to the supply port 12 via a supply flow path 14 formed in the interior of the substrate table 4T, and a suction apparatus 21, which is able to suction the fluid via the suction port 22 and a suction flow path 24 formed in the interior of the substrate table 4T. The liquid supply apparatus 11 comprises a temperature adjustment apparatus that adjusts the temperature of the supplied liquid LQ, a filter unit, which removes foreign matter in the liquid LQ, etc., and it is able to supply the liquid LQ, which is clean and has been temperature adjusted. The suction apparatus 21 comprises a vacuum system, etc., and it is able to suction the fluid. In the present embodiment, glycerol (glycerin) is used as the liquid LQ.

The suction port 22 is provided in the vicinity of the supply port 12. In the present embodiment, as shown in FIG. 2B, the suction port 22 is annularly provided in the vicinity of the supply port 12 so as to surround the supply port 12. In the present embodiment, the suction port 22 is annularly (ring-shape) formed so as to surround the supply port 12, but it may also be formed in a rectangular shape (rectangular ring shape). In addition, suction ports 22 that have a prescribed diameter may be formed so that they are plurally arrayed so as to surround the supply port 12.

In addition, the liquid immersion system 1 comprises a detection apparatus 30, which detects whether or not a prescribed space between the concave surface 2 and the substrate table 4T has been filled with the liquid LQ. The detection apparatus 30 of the present embodiment detects the presence or absence of gas (including bubbles) of a prescribed space between the concave surface 2 and the substrate table 4T by detecting the status of the fluid that flows through a suction flow path 24. The detection results of the detection apparatus 30 are output to the control apparatus 7. The control apparatus 7 discriminates the presence or absence of gas in the liquid LQ that fills the space between the concave surface 2 and the substrate table 4T. In addition, the control apparatus 7 controls at least one of the supply operation of the supply port 12 or the suction operation of the suction port 22 based on the detection results of the detection apparatus 30.

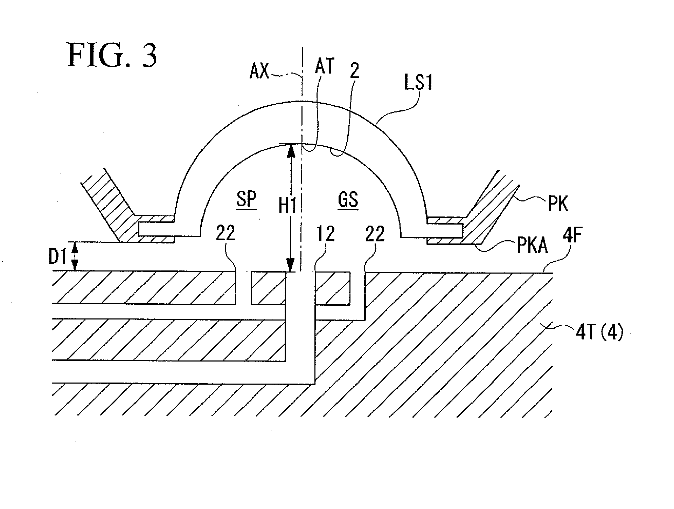

FIG. 3 shows an example of a status in which the supply port 12 and the suction port 22 on the substrate table 4T are placed in opposition with the concave surface 2 of the final optical element LS 1. The suction port 22 is arranged in the vicinity of the supply port 12, and the control apparatus 7 is able to place the supply port 12 and the suction port 22 on the substrate table 4T in opposition with the concave surface 2 of the final optical element LS 1 by driving the substrate stage 4 by controlling the substrate stage driving apparatus. In the present embodiment, when the liquid LQ is supplied from the supply port 12, the control apparatus 7 arranges the supply port 12 on the optical axis AX of the final optical element LS1. The control apparatus 7 is able to arrange the supply port 12 on the optical axis AX of the final optical element LS1 by measuring the position information of the substrate table 4T using a laser interferometer 4L while controlling the substrate stage drive apparatus. In the aforementioned way, the projection optical system PL, which includes the final optical element LS1, has an optical axis AX that is parallel with the vertical direction. The optical axis AX passes through the position farthest from the upper surface 4F of the substrate table 4T (hereunder, referred to as the apex position) AT. Therefore, the supply port 12 arranged on the optical axis AX of the final optical element LS 1 is arranged at a position that is in opposition with the apex position AT of the concave surface 2. The supply port 12 starts supply of the liquid LQ in a status in which it is arranged on the optical axis AX of the final optical element LS 1.

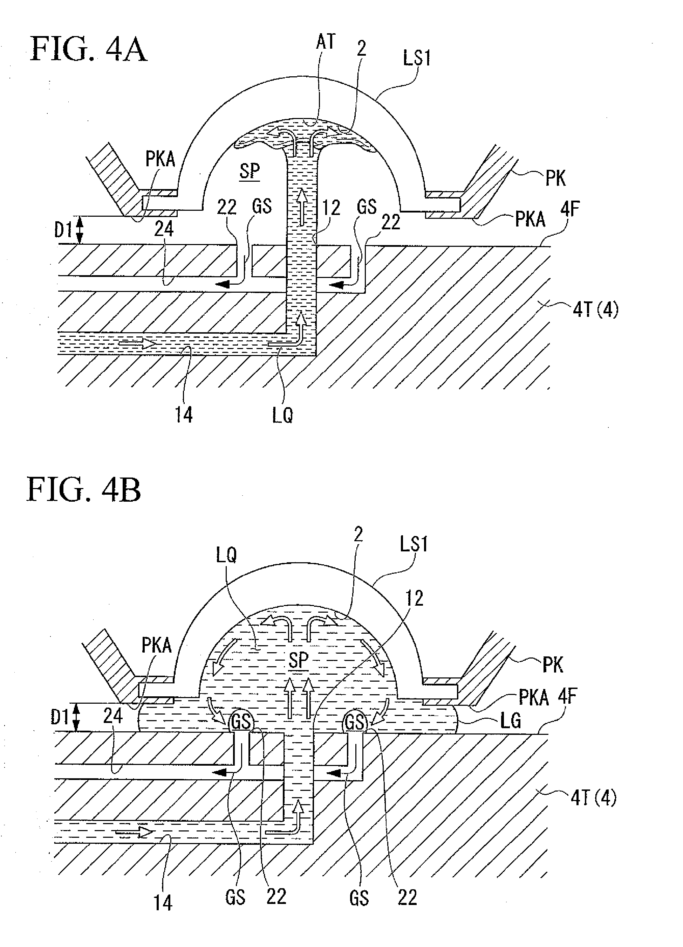

Next, the method of exposing the substrate P using an exposure apparatus EX having the configuration discussed above will be explained while referring to the schematic drawings of FIG. 4A to FIG. 7.

First, the control apparatus 7 uses a liquid immersion system 1 to fill a prescribed space SP of the light emittance side of the concave surface 2 of the final optical element LS 1, which includes the optical path K of the exposure light EL, with the liquid LQ. In the initial status of the exposure apparatus EX prior to performing the prescribed operation relating to exposure, the liquid LQ is not present in the prescribed space SP that includes the optical path K. The control apparatus 7, in a status in which the concave surface 2 of the final optical element LS1 and the supply port 12 and the suction port 22 on the substrate table 4T have been placed in opposition, supplies the liquid LQ to the optical path K, where the liquid LQ is not present, from a supply port 12 and uses the liquid LQ to fill the prescribed space SP that includes that optical path K. In the explanation below, a prescribed space SP, which includes the optical path K of the exposure light EL in the initial status in which the liquid LQ is not present, is filled with the liquid LQ, so the operation of supplying the liquid LQ to that prescribed space SP is appropriately referred to as the initial filling operation.

In performing the initial filling operation, the control apparatus 7 drives the substrate stage 4, and, as shown in FIG. 3, the concave surface 2 of the final optical element LS1 and the supply port 12 and the suction port 22 on the substrate table 4T are placed in opposition, and the suction port 12 is arranged on the optical axis AX of the final optical element LS1. Then, the control apparatus 7 drives the liquid supply apparatus 11 of the liquid immersion system 1 and starts supply of the liquid LQ to the prescribed space SP between the concave surface 2 and the substrate table 4T. After the liquid LQ that has been sent out from the liquid supply apparatus 11 has flowed through the supply flow path 14, it is supplied to the prescribed space SP from the supply port 12. In order to fill the prescribed space SP between the concave surface 2 and the substrate table 4T with the liquid LQ, the supply port 12 supplies the liquid LQ to that prescribed space SP.

FIG. 4A shows the status immediately after supply of the liquid LQ from the supply port 12 has started. As shown in FIG. 4A, the liquid immersion system 1 sprays out the liquid LQ from the supply port 12 so that it strikes the apex position AT of the concave surface 2. In the present embodiment, the distance H1 between the supply port 12 and the apex position AT of the concave surface 2 (see FIG. 3) is set to approximately 50 to 60 mm, the diameter of the concave surface 2 is set to approximately 100 to 120 mm, and the liquid immersion system 1 sprays out the liquid (glycerin) LQ from the supply port 12 at a flow rate at 1 m/sec or more. Through this, the liquid immersion system 1 is able to spray out the liquid LQ from the supply port 12 so that it strikes the concave surface 2.

In addition, the control apparatus 7 starts driving of the suction apparatus 21 at a prescribed timing with respect to the time that supply of the liquid LQ from the supply port 12 started and starts suction of the fluid from the suction port 22. In the present embodiment, the control apparatus 7 starts suction of fluid from the suction port 22 nearly simultaneously with the point when supply of the liquid LQ from the supply port 12 started. Immediately after the operation of supplying the liquid LQ from the supply port 12 has started, the suction port 22 mainly suctions the gas GS. The suction port 22 suctions (exhausts) the fluid (the gas GS) of the prescribed space SP between the concave surface 2 and the substrate table 4T in parallel with the operation of supplying the liquid LQ from the supply port 12. The fluid that has been suctioned from the suction port 22 by means of the driving of the suction apparatus 21 is suctioned by the suction apparatus 21 after it has flowed through the suction flow path 24.

Note that the timing of starting the operation of suction from the suction port 22 may be before or after the operation of supplying the liquid LQ using the supply port 12 is started.

The liquid LQ supplied (sprayed out) from the supply port 12 to the prescribed space SP flows along the concave surface 2 after it has struck the concave surface 2. The control apparatus 7 continues the supply operation of the supply port 12 and the suction operation of the suction port 22. The flow of the liquid LQ that is sprayed out from the supply port 12 to the space between the concave surface 2 and the substrate table 4T is at a high speed flow rate of several m/sec., so the pressure of the space in the vicinity of the supply port 12 decreases. For that reason, the pressure of the space in the vicinity of the suction port 22, which is provided in the vicinity of the supply port 12, also decreases. The gas GS in the liquid LQ collects in spaces where the pressure is low, so it collects in the vicinity of the suction port 22. In other words, by using the flow of the liquid LQ supplied from the supply port 12 to the prescribed space SP to reduce the pressure near the suction port 22 provided in the vicinity of that supply port 12, it is possible to collect the gas GS in the liquid LQ in the vicinity of the suction port 22. That is, in the present embodiment, the suction port 22 is provided in the vicinity of the position where the gas GS collects by means of the flow of the liquid LQ supplied from the supply port 12 to the space between the concave surface 2 and the substrate table 4T. By continuing supply of the liquid LQ from the supply port 12, the prescribed space SP between the concave surface 2 and the substrate table 4T is gradually filled with the liquid LQ.

FIG. 4B shows the status immediately before the prescribed space SP is filled with the liquid LQ. As shown in FIG. 4B, in the prescribed space SP between the concave surface 2 and the substrate table 4T, the prescribed flow of the liquid LQ is produced according to the flow of the liquid LQ supplied from the supply port 12, the shape of a concave surface 2, etc. In addition, by providing the supply port 22 in the vicinity of the position where the gas GS collects, as shown in FIG. 4B, it is possible to smoothly exhaust gas GS (including bubbles) in the liquid LQ, which fills the prescribed space SP, from the prescribed space SP via the suction port 22.

In order to fill the prescribed space SP with the liquid LQ, when the liquid supply operation of the supply port 12 is executed, the control apparatus 7 sets the space between the lower surface PKA of the lens barrel PK and the upper surface 4F of the substrate table 4T to a prescribed gap D1. Here, in the present embodiment, the lower surface PKA of the lens barrel PK is the surface that is nearest the upper surface 4F of the substrate table 4T from among the members that oppose the upper surface 4F of the substrate table 4T. By optimally setting the gap D1 according to the properties of the liquid LQ (surface tension, density, etc.), the volume of the liquid LQ that fills the prescribed space SP (the distance H1 between the supply port 12 and the apex position AT of the concave surface 2, the size of the liquid immersion region LR), the contact angle of the upper surface 4F with respect to the liquid LQ, the contact angle of lower surface PKA with respect to the liquid LQ, etc., it is possible to maintain the edge LG of the liquid immersion region LR between the upper surface 4F and the lower surface PKA, and it is possible to restrict outflow of the liquid LQ.

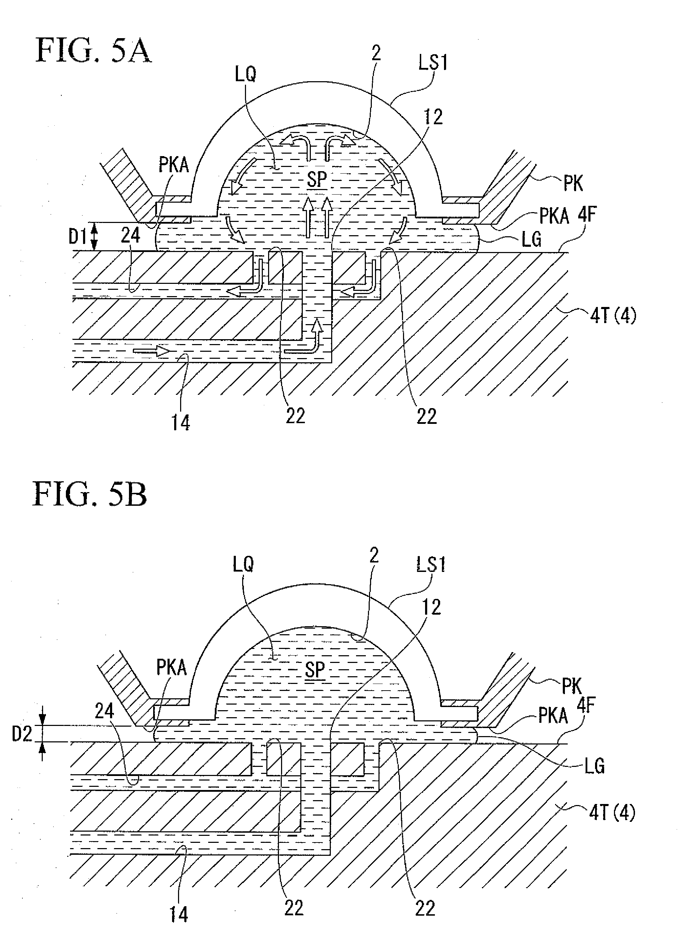

In addition, the control apparatus 7 continues the supply operation of the supply port 12 and the fluid (including the liquid LQ and the gas GS) suction operation of the suction port 22 until the gas GS of the prescribed space SP is eliminated (or until the volume of the gas GS becomes at or below a tolerance value that has been set in advance). The liquid immersion system 1, by discharging (exhausting) the gas GS of the prescribed space SP and performing the liquid LQ supply operation, is able to discharge the gas GS of the prescribed space SP well via the suction port 22, and, as shown in FIG. 5A, is able to use the liquid LQ supplied from the supply port 12 to fill the prescribed space SP between the concave surface 2 and the substrate table 4T well without causing the gas GS to remain in the prescribed space SP.

As shown in FIG. 2A and FIG. 2B, the liquid immersion system 1 comprises a detection apparatus 30 that detects the presence or absence of the gas GS of the prescribed space SP between the concave surface 2 and the substrate table 4T, and the control apparatus 7 controls the supply operation of the supply port 12 and the suction operation of the suction port 22 based on the detection results of the detection apparatus 30. Specifically, the control apparatus 7 continues the supply operation of the supply port 12 and the suction operation of the suction port 22 until it has been determined that the gas GS of the prescribed space SP has been eliminated (until it has been determined that the prescribed space SP has been filled with the liquid LQ) based on the detection results of the detection apparatus 30.

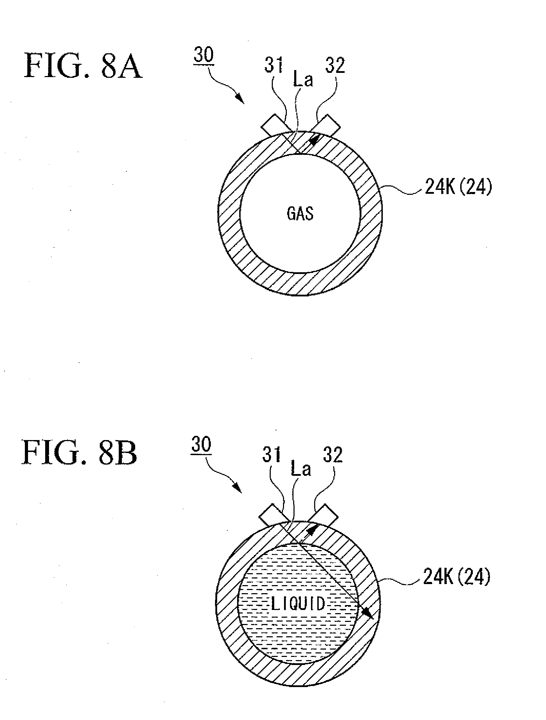

FIG. 8A and FIG. 8B are drawings that show an example of the detection apparatus 30. The detection apparatus 30 of the present embodiment optically detects the status of the fluid that flows through the suction flow path 24 that connects the suction port 22 and the suction apparatus 21 using detection light La. The detection apparatus 30 comprises a projection system 31, which is able to emit the detection light La, and a light reception system 32, which is provided at a prescribed position with respect to the detection light La that is emitted from the projection system 31 and is able to receive the detection light La. In addition, at least a portion of the suction flow path 24 of the present embodiment is formed by a pipe member 24K of a material that has a prescribed refractive index with respect to the detection light La and that is able to transmit the detection light La. The fluid (including the liquid LQ and the gas GS) suctioned from the suction port 22 flows through the inside of the pipe member 24K. The projection system 31 irradiates the detection light La from outside the pipe member 24K at a prescribed angle of incidence with respect to the inside of the pipe member 24K.

In the case where the liquid LQ is present and in the case where the gas GS is present inside the pipe member 24K, the statuses of reception of the detection light La by the light reception system 32 mutually differ, and the detection apparatus 30 is able to discriminate whether the liquid LQ is present or the gas GS is present inside the pipe member 24K based on the light reception results of the light reception system 32. For example, as shown in FIG. 8A, when the gas GS is present inside the pipe member 24K, the detection light La that has been emitted from the projection system 31 is reflected by the interface of the pipe member 24K and the gas GS at the inside thereof and reaches the light reception system 32 at a first quantity of light. On the other hand, as shown in FIG. 8B, in the case were the liquid LQ is present inside the pipe member 24K, the detection light La that has been emitted from the projection system 31, for example, passes through the interface of the pipe member 24K and the liquid LQ at the inside thereof and does not reach the light reception system 32 or reaches it at a second quantity of light that is different from the first quantity of light.

In this way, the statuses of reception of the detection light La by the light reception system 32 mutually differ in the case where the liquid LQ is present and in the case where the gas GS is present inside the pipe member 24K.

In a status where the supply operation of the supply port 12 and the suction operation of the suction port 22 are continually performed with respect to the prescribed space SP, in the case where the gas GS is present in the prescribed space SP, the gas GS flows to the pipe member 24K. On the other hand, in the case where all of the prescribed space SP is filled with the liquid LQ, only the liquid LQ flows to the pipe member 24K. Therefore, the control apparatus 7 is able to discriminate the presence or absence of the gas GS of the prescribed space SP between the concave surface 2 and the substrate table 4T based on the detection results of the detection apparatus 30. The control apparatus 7 continues the supply operation of the supply port 12 and the suction operation of the suction port 22 for a prescribed period of time even after the gas GS of the prescribed space SP has been eliminated until only the liquid LQ has been suctioned from the suction port 22 and only the liquid LQ flows to the pipe member 24K of the suction flow path 24.

When it has been determined that there is no gas GS in the prescribed space SP between the concave surface 2 and the substrate table 4T based on the detection results of the detection apparatus 30, as shown in FIG. 5B, the control apparatus 7 stops the supply operation of the supply port 12 and the suction operation of the suction port 22. With this, the initial filling operation ends. On the other hand, when it has been determined that gas GS is present in the prescribed space SP that fills the space between the concave surface 2 and the substrate table 4T based on the detection results of the detection apparatus 30, the control apparatus 7 continues the supply operation of the supply port 12 and the suction operation of the suction port 22 until the gas GS of the prescribed space SP is eliminated (until the detection apparatus 30 no longer detects the gas GS). In addition, as shown in FIG. 5B, when the supply operation of the supply port 12 has been stopped, the control apparatus 7 is able to set the space between the lower surface PKA of the lens barrel PK and the surface of the substrate P to a prescribed gap D2. Here, gap D1 is larger than gap D2. Specifically, during stoppage of the supply operation of the supply port 12, the prescribed space SP between the concave surface 2 and the substrate table 4T is made smaller in comparison with during execution of the supply operation of the supply port 12. In other words, during execution of the supply operation of the supply port 12, the positional relationship between the concave surface 2 and the substrate table 4T is adjusted so that the prescribed space SP between the concave surface 2 and the substrate table 4T becomes larger than during stoppage of the supply operation of the supply port 12.

The gap D2 during stoppage of the supply operation of the supply port 12 is also optimally set according to the properties of the liquid LQ (surface tension, density, etc.), the volume of the liquid LQ that fills the prescribed space SP (the distance between the supply port 12 and the apex position AT of the concave surface 2, the size of the liquid immersion region LR), the contact angle of the upper surface 4F of the substrate table 4T with respect to the liquid LQ, the contact angle of lower surface PKA with respect to the liquid LQ, etc. Through this, it is possible to maintain the edge LG of the liquid immersion region LR between the upper surface 4F of the substrate table 4T and the lower surface PKA, and it is possible to restrict outflow of the liquid LQ.

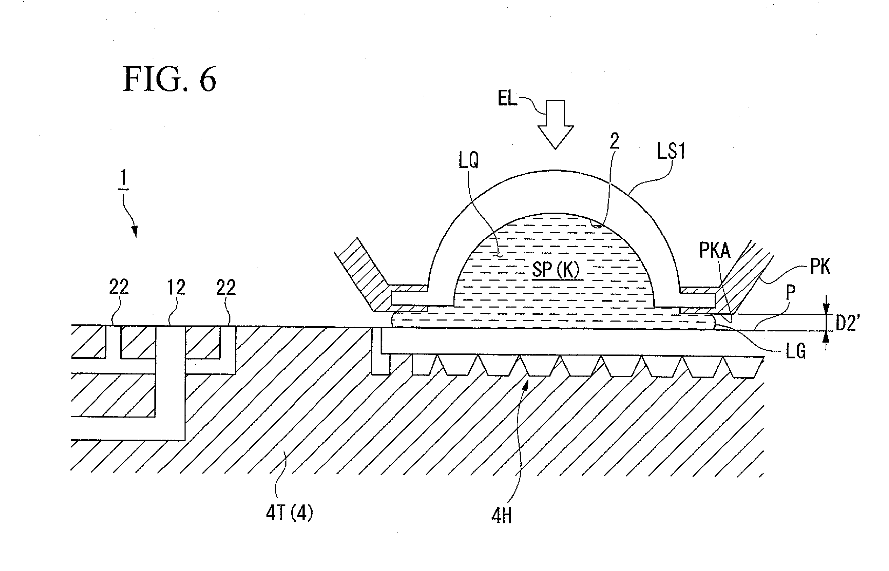

After the prescribed space SP between the concave surface 2 and the substrate table 4T has been filled with the liquid LQ and the supply operation of the supply port 12 and the suction operation of the suction port 22 have been stopped, the control apparatus 7 places the concave surface 2 and the surface of the substrate P in opposition. The control apparatus 7 is able to place the concave surface 2 and the surface of the substrate P in opposition as shown in FIG. 6 by moving the substrate stage 4 in the XY direction with respect to the projection optical system PL and the liquid LQ. Then, the control apparatus 7 irradiates exposure light EL onto the substrate P via a projection optical system PL that includes the final optical element LS1, which has a concave surface 2, and the liquid LQ in a status in which concave surface 2 and the surface of the substrate P have been placed in opposition.

In present embodiment, the control apparatus 7 exposes the substrate P via the liquid LQ that is held in the space between the concave surface 2 and the surface of the substrate P in a status in which the liquid LQ supply operation and suction (recovery) operation with respect to the prescribed space SP between the concave surface 2 and the surface of the substrate P have been stopped. When exposure of the substrate P is performed, the positional relationship of the projection optical system PL and the substrate P in the Z axis direction and the θX and θY directions is adjusted to put the image plane formed via the projection optical system PL and the liquid LQ and the surface of the substrate P into the prescribed positional relationship.

As shown in FIG. 6, when the supply operation of the supply port 12 is stopped, such as during exposure of the substrate P, the space between the lower surface PKA of the lens barrel PK and the surface of the substrate P is set to a prescribed gap D2'. Gap D2' is smaller than gap D1. That is, during stoppage of the supply operation of the supply port 12, such as during exposure of the substrate P, the positional relationship between the concave surface 2 and the substrate P is adjusted so that the prescribed space SP between the concave surface 2 and the substrate P becomes smaller than during execution of the supply operation of the supply port 12, such as during the initial filling operation. Note that gap D2' may be the same as or different from gap D2.

In addition, gap D2' during exposure of the substrate P is also optimally set according to the properties of the liquid LQ (surface tension, density, etc.), the volume of the liquid LQ that fills the prescribed space SP (the distance between the supply port 12 and the apex position AT of the concave surface 2, the size of the liquid immersion region LR), the contact angle of the surface the substrate P with respect to the liquid LQ, the contact angle of lower surface PKA with respect to the liquid LQ, etc. Through this, it is possible to maintain the edge LG of the liquid immersion region LR between the surface of the substrate P and the lower surface PKA, and even when the substrate P is being exposed, it is possible to restrict outflow of the liquid LQ.

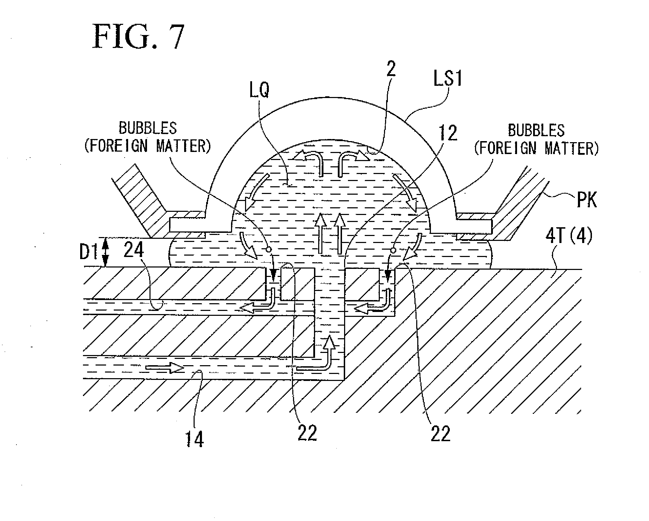

Note that, in present embodiment, the control apparatus 7 is able to recover (remove) foreign matter such as bubbles, particles, etc. in the liquid LQ of the prescribed space SP via the suction port 22 by performing the liquid supply operation of the supply port 12 and the fluid (mainly, the liquid LQ) suction (recovery) operation of the suction port 22 in parallel in a status in which the prescribed space SP has been filled with the liquid LQ. For example, as shown in FIG. 7, the control apparatus 7 is able to place the concave surface 2 in opposition with the supply port 12 and the suction port 22 by moving the substrate stage 4 with respect to the projection optical system PL in the XY direction. Furthermore, by performing the supply operation of the supply port 12 and the suction operation of the suction port 22 in parallel and using the suction port 22 to suction the bubbles (foreign matter), etc. in the liquid LQ that fills the prescribed space SP along with the liquid LQ in a status in which the concave surface 2 and the supply port 12 and the suction port 22 have been placed in opposition, the control apparatus 7 is able to remove those bubbles (foreign matter) from inside the liquid LQ that fills the prescribed space SP.

In addition, by performing the supply operation of the supply port 12 and the suction operation of the suction port 22 in parallel in a status in which the prescribed space SP has been filled with the liquid LQ, the control apparatus 7 is able to perform replacement (exchange) of the liquid LQ that fills the prescribed space SP. When the liquid LQ of the prescribed space SP is replaced, the control apparatus 7 may exchange all of the liquid LQ that fills the prescribed space SP (full replacement) or may exchange a part of the liquid LQ (partial replacement).

Note that the operation of performing the supply operation of the supply port 12 and the suction operation of the suction port 22 in parallel (including the foreign matter removal operation and the liquid LQ replacement operation) in a status in which the prescribed space SP has been filled with the liquid LQ may be performed, for example, at each prescribed time interval, at each prescribed number of substrates processed, at each lot, etc.

As explained above, the supply port 12, which supplies the liquid LQ to the prescribed space SP that includes the optical path K of the exposure light EL, and the suction port 22, which suctions the fluid LQ, GS, are provided on the substrate table 4T, which can be placed in opposition with the concave surface 2 of the final optical element LS1, so it is possible to fill the prescribed space SP of the light emittance side of the concave surface 2 with the liquid LQ well. Therefore, it is possible to cause the exposure light EL to reach onto the substrate P well.

In addition, by performing the supply operation of the supply port 12 and the suction operation of the suction port 22 in parallel, during the initial filling operation, the gas GS of the prescribed space SP is quickly discharged (exhausted), the gas portion (including bubbles) is restricted from remaining in the prescribed space SP, and it is possible to fill the optical path K of the exposure light EL with the liquid LQ well. In addition, by performing supply of the liquid LQ of the supply port 12 and the suction of the fluid of the suction port 22 in parallel in a status in which the prescribed space SP of the inside the concave surface 2 has been filled with the liquid LQ, it is possible to remove foreign matter (bubbles) in the liquid LQ and perform exchange (replacement) of the liquid LQ.

The suction port 22 is provided at a position at which the gas GS and/or the foreign matter collects by means of the flow of the liquid LQ supplied from the supply port 12 to the space between the concave surface 2 and the substrate table 4T, so it is possible to suction and discharge the gas GS and/or the foreign matter of the prescribed space SP well.

In addition, the supply port 12 is arranged on the optical axis AX of the final optical element LS1, and the liquid LQ is sprayed out from that supply port 12 so that it strikes the concave surface 2, so the liquid LQ that has struck the concave surface 2 flows along the concave surface 2. Therefore, it is possible to wet the concave surface 2 well with the liquid LQ, and it is possible to fill up to the vicinity of the apex position AT with the liquid LQ well.

Since a detection apparatus 30 that detects the presence or absence of the gas GS of the prescribed space SP between the concave surface 2 and the substrate table 4T is provided, the control apparatus 7 is able to perform the liquid LQ supply operation until the prescribed space SP is filled with the liquid LQ. In addition, it is also possible to restrict the initial filling operation from continuing even though the prescribed space SP has been filled with the liquid LQ.

During execution of the supply operation of the supply port 12, the positional relationship between the concave surface 2 and the object is adjusted so that the space between the concave surface 2 and objects (substrate table 4T and the substrate P) that have been placed in opposition with that concave surface 2 is larger than during stoppage of the supply operation of the supply port 12, so it is possible to restrict the final optical element LS1, etc. from being affected attributable to the liquid supply operation of the liquid supply port 12. Specifically, during execution of the supply operation of the supply port 12, such as during the initial filling operation, there is a possibility that the pressure of the liquid LQ between the concave surface 2 and objects placed in opposition with that concave surface 2 will rise attributable to the liquid LQ supplied (sprayed out) from the supply port 12. During the execution of the supply operation of the supply port 12, in the case where the space between the concave surface 2 and the object has been made smaller, there is a possibility that the pressure of the liquid LQ between the concave surface 2 and the object will rise, for example that the force of the liquid LQ will greatly act on the final optical element LS1 and affect on the final optical element LS. In the present embodiment, during execution of the supply operation of the supply port 12, in comparison with during stoppage of the supply operation of the supply port 12, the gap between the lower surface PKA of the lens barrel PK and the object is adjusted so that the prescribed space SP between the concave surface 2 and the object becomes larger to make it easier for the interface of the liquid LQ formed between of the lower surface of the lens barrel PK and the upper surface 4F of the substrate table 4T to move, so it is possible to restrict excessive rises in the pressure of the prescribed space SP during execution of the supply operation of the supply port 12. In addition, during stoppage of the supply operation of the supply port 12, it is possible to restrict outflow of the liquid LQ of the prescribed space SP, and it is possible to form gaps D2, D2' so that the desired position with respect to the object (substrate) results.

<Second Embodiment>

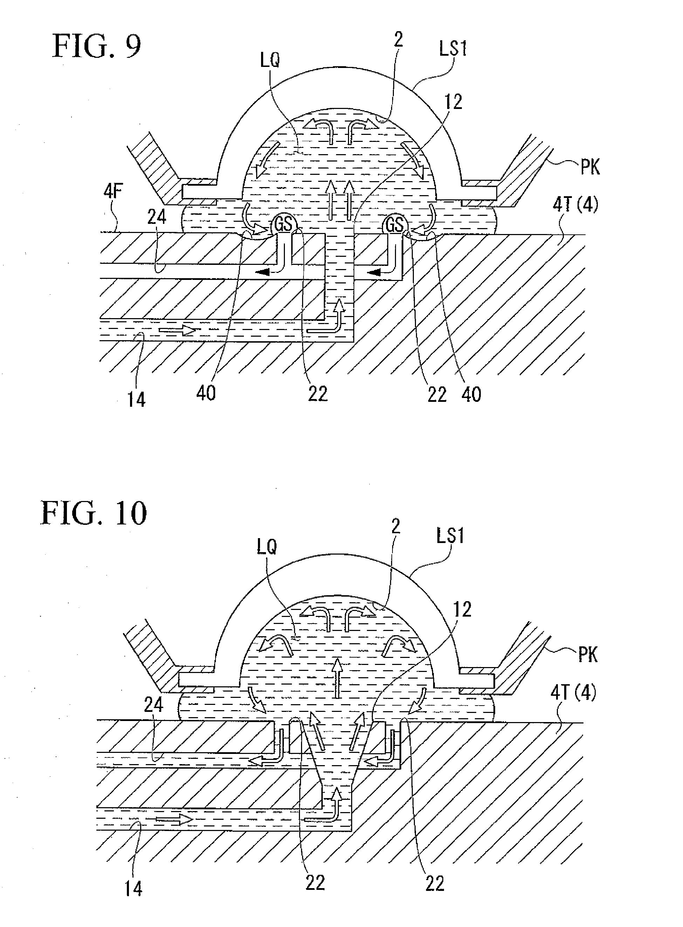

A second embodiment will be explained while referring to FIG. 9. In the explanation below, identical codes are assigned to constituent portions that are identical to or similar to those of the embodiment discussed above, and explanations thereof have been abbreviated or omitted.

As shown in FIG. 9, the liquid immersion system 1 of the present embodiment, similarly to the first embodiment discussed above, comprises a supply port 12 arranged on the optical axis AX of the final optical element LS1 and a suction port 22 provided so as to surround the supply port 12. In addition, a concave part 40 is provided on a portion of the upper surface 4F of the substrate table 4T. And the concave part 40 is provided in the vicinity of the suction port 22. In the present embodiment, the concave part 40 is provided so as to surround the outside of the suction port 22. The concave part 40 is provided at a position at which it can be placed in opposition with the concave surface 2 of the final optical element LS 1 when the supply port 12 has been arranged on the optical axis AX of the final optical element LS1.

In the present embodiment, the inner surface of the concave part 40 is a curved surface that sinks in so that it separates from the final optical element LS1.

Note that the inner surface of the concave part 40 may be, for example, of a shape that combines a plurality of flat surfaces that face mutually different directions.

As discussed above, through the flow of the liquid LQ that is supplied from the supply port 12 to the prescribed space SP, it is possible to reduce the pressure of the space in the vicinity of the suction port 22 provided in the vicinity of that supply port 12, and it is possible to collect the gas GS in the vicinity of the suction port 22. In addition, the liquid LQ that has been sprayed out from the suction port 12 flows toward the upper surface 4F of the substrate table 4T so that it strikes the concave surface 2 of the final optical element LS1 and flows along the concave surface 2, so there is a possibility that a vortex of the liquid LQ will occur in the vicinity of the edge of the concave surface 2 and that the gas GS (bubbles) will remain in the center of that vortex, but in the present embodiment, the concave part 40 is provided, so even if a vortex of the liquid LQ were to occur, the center of that vortex would be formed in the vicinity of the upper surface 4F of the substrate table 4T (in the vicinity of the suction port 22). Therefore, at times such as that of the initial filling operation, it is possible to more quickly discharge the gas GS (bubbles) in the liquid LQ that fills the prescribed space SP via the suction port 22.

<Third Embodiment>

A third embodiment will be explained while referring to FIG. 10. In the explanation below, identical codes are assigned to constituent portions that are identical or similar to those of the embodiments discussed above, and explanations thereof have been abbreviated or omitted. As shown in FIG. 10, at least a portion of the supply flow path 14 connected to the supply port 12 may be formed in a tapered shape (horn shape) that gradually widens as it approaches the supply port 12. Through this, at such times as that of the initial filling operation, it is possible to put the flow of the liquid LQ for filling the prescribed space SP into the desired status, and it is possible to restrict the gas GS from remaining in the liquid LQ that fills the prescribed space SP.

In addition, it is also possible to restrict the gas GS from remaining in the prescribed space SP by optimizing the diameter of the supply port 12 according to the diameter of the concave surface 2 of the final optical element LS1. For example, it is possible to restrict the gas GS from remaining in the prescribed space SP by setting the diameter of the supply port 12 to 1/3 or more the diameter of the concave surface 2 of the final optical element LS1.

<Fourth Embodiment>

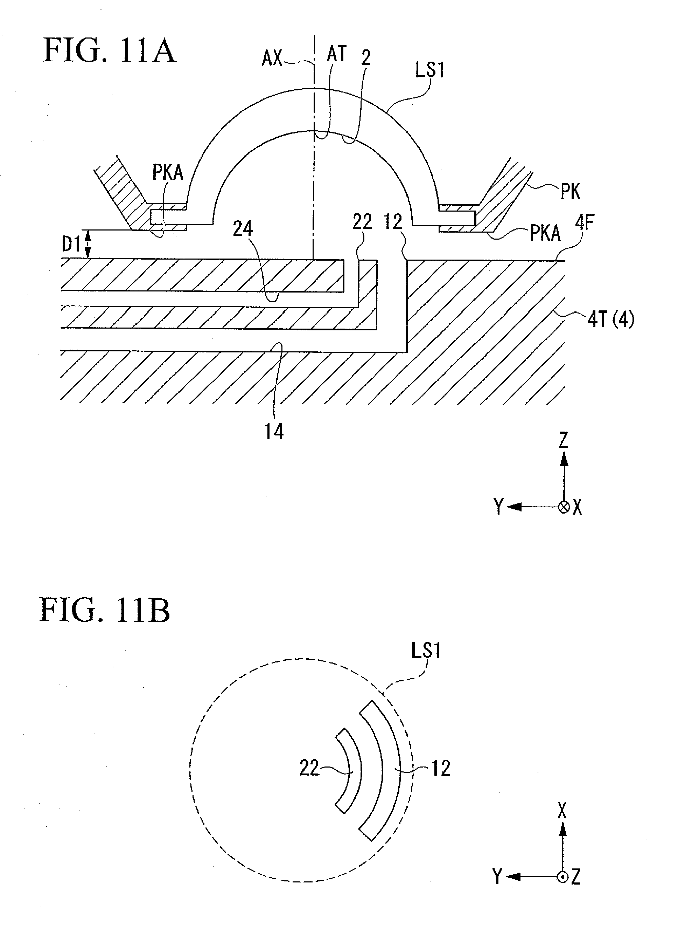

Next, a fourth embodiment will be explained while referring to FIG. 11A to FIG. 13B. In the explanation below, identical codes are assigned to constituent portions that are identical or similar to those of the embodiments discussed above, and explanations thereof have been abbreviated or omitted. In the present embodiment, when the prescribed space SP initial filling operation is performed, the control apparatus 7 arranges the supply port 12 at a prescribed position that opposes the peripheral part of the concave surface 2 of the final optical element LS1. The supply port 12 performs supply of the liquid LQ in a status in which it has been arranged at a prescribed position that opposes the peripheral part of the concave surface 2 of the final optical element LS1.

The suction port 22 is provided in the vicinity of the supply port 12. In the present embodiment, the suction port 22 is arranged between the optical axis AX of the final optical element LS 1 and the supply port 12 when the supply port 12 is arranged at a prescribed position that opposes the peripheral part of the concave surface 2. In this way, in the present embodiment as well, when the initial filling operation is performed, the control apparatus 7 controls the substrate stage drive apparatus to drive the substrate stage 4 and place the supply port 12 and the suction port 22 on the substrate table 4T in opposition with the concave surface 2 of the final optical element LS 1.

In the present embodiment, the respective supply port 12 and suction port 22 are formed into arcuate slit shapes on the upper surface 4F of the substrate table 4T. In addition, in the present embodiment, the supply port 12 is formed to be larger than the suction port 22.

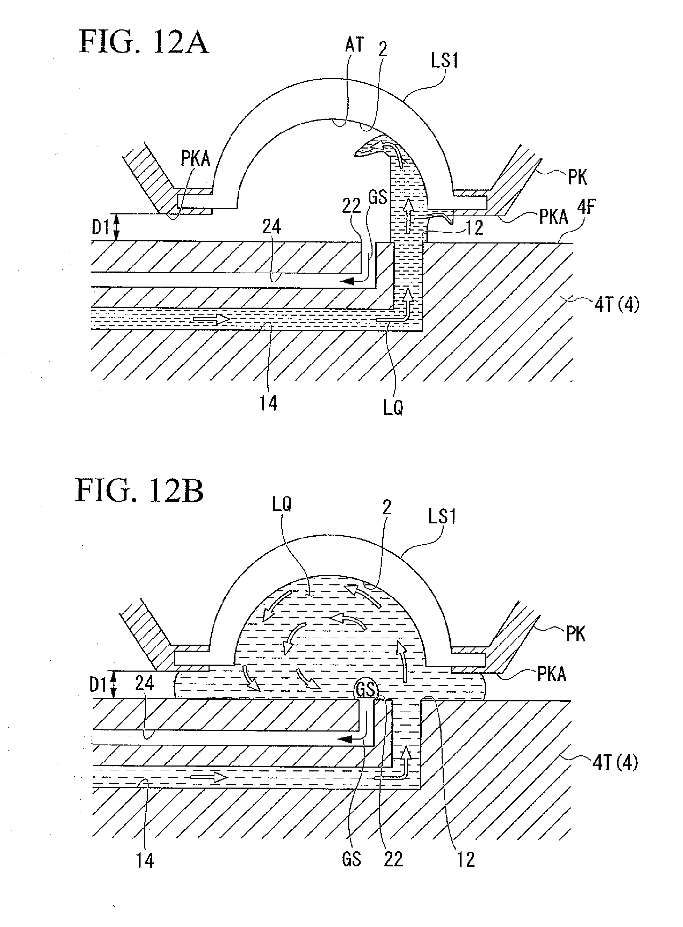

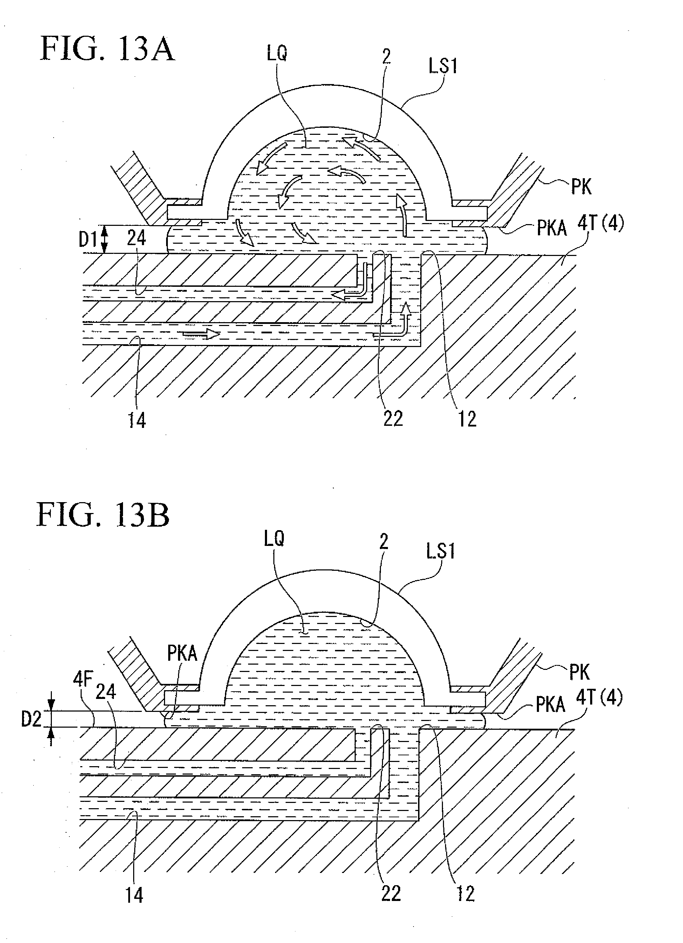

Next, the procedures of the initial filling operation will be explained while referring to the schematic drawings of FIG. 12A, FIG. 12B, FIG. 13A and FIG. 13. In performing the initial filling operation, the control apparatus 7 drives the substrate stage 4, places the concave surface 2 of the final optical element LS1 and the supply port 12 and the suction port 22 on the substrate table 4T in opposition as shown in FIG. 11A and FIG. 11B, and arranges the supply port 12 at a prescribed position that opposes the peripheral part of the concave surface 2 of the final optical element LS1. In addition, the control apparatus 7 drives the liquid supply apparatus 11 of the liquid immersion system 1 to start supply of the liquid LQ with respect to the prescribed space SP between the concave surface 2 and substrate table 4T. The liquid LQ that has been sent from the liquid supply apparatus 11 is supplied to the prescribed space SP from the supply port 12 after having flowed through the supply flow path 14.

FIG. 12A shows the status immediately after supply of the liquid LQ from the supply port 12 has started. As shown in FIG. 12A, the liquid immersion system 1 sprays the liquid LQ out from the supply port 12 so that it strikes the peripheral part of the concave surface 2. In the present embodiment as well, the distance between the supply port 12 and the apex position AT of the concave surface 2 is set to approximately 50 to 60 mm, the diameter of the concave surface 2 is set to approximately 100 to 120 mm, and the liquid immersion system 1 sprays the liquid (glycerin) LQ out from the supply port 12 at a flow rate of 1 m/sec or more. Through this, the supply port 12 is able to spray the liquid LQ out so that it strikes the peripheral part of the concave surface 2, and the liquid LQ supplied to the peripheral part of the concave surface 2 is able to reach along the concave surface 2 up to the apex position AT of the concave surface 2.

In addition, the control apparatus 7 starts driving of the suction apparatus 21 and starts suction of the fluid from the suction port 22 at a prescribed timing with respect to the time that supply of the liquid LQ from the supply port 12 has started. The suction port 22 suctions (exhausts) the fluid (the gas GS) of the prescribed space between the concave surface 2 and the substrate table 4T in parallel with the operation of supplying the liquid LQ from the supply port 12.

The liquid LQ that has been supplied (sprayed out) from the supply port 12 to the prescribed space SP flows so that it follows the concave surface 2 after striking the concave surface 2. The control apparatus 7 continues the supply operation of the supply port 12 and the suction operation of the suction port 22. In the present embodiment as well, the flow of the liquid LQ from the supply port 12 to the prescribed space SP is at a high flow rate of several m/sec period, so it is possible to reduce the pressure of the space in the vicinity of the suction port 22 provided in the vicinity of the supply port 12, and it is possible to collect the gas GS in the liquid LQ in the vicinity of the suction port 22. In this way, in the present embodiment as well, the suction port 22 is provided in the vicinity of the position where the gas GS collects due to flow of the liquid LQ that has been supplied from the supply port 12 to the space between the concave surface 2 and the substrate table 4T. The prescribed space SP between the concave surface 2 and the substrate table 4T is gradually filled with the liquid LQ by continuing supply of the liquid LQ from the supply port 12.

FIG. 12B shows the status immediately before the prescribed space SP is filled with the liquid LQ. As shown in FIG. 12B, in the prescribed space SP between the concave surface 2 and the substrate table 4T, the prescribed flow of the liquid LQ is generated according to the flow of the liquid LQ supplied from the supply port 12, the shape of the concave surface 2, etc. In addition, by having provided the suction port 22 in the vicinity of the position where the gas GS collects, as shown in FIG. 12B, it is possible to smoothly discharge the gas (including bubbles) GS of the prescribed space SP from the prescribed space SP via that suction port 22.

Then, the control apparatus 7 continues the liquid LQ supply operation of the supply port 12 and the fluid (including the liquid LQ and the gas GS) suction operation of the suction port 22 until the gas GS of the prescribed space SP is eliminated (or until the amount of the gas GS has become at or below a tolerance value that has been determined in advance). The liquid immersion system I is able to exhaust the gas GS of the prescribed space SP via the suction port 22 well by discharging (exhausting) the gas GS of the prescribed space SP while performing the liquid LQ supply operation, and, as shown in FIG. 13A, it is possible to fill the prescribed space SP between the concave surface 2 and the substrate table 4T well with the liquid LQ supplied from supply port 12 without causing the gas GS to remain in the liquid LQ of the prescribed space SP. In the present embodiment as well, the control apparatus 7 continues the supply operation of the supply port 12 and the suction operation of the suction port 22 until it has been determined that the gas GS has been eliminated from the prescribed space SP (until it has been determined that the prescribed space SP has been filled with the liquid LQ) based on the detection results of the detection apparatus 30.

When it has been determined that there is no gas GS in the prescribed space SP between the concave surface 2 and the substrate table 4T based on the detection results of the detection apparatus 30, the control apparatus 7 stops the supply operation of the supply port 12 and the suction operation of the suction port 22 as shown in FIG. 13B. With this, the initial filling operation ends.

In addition, as shown in FIG. 13B, the control apparatus 7 is able to adjust the gap between the lower surface PKA of the lens barrel PK and the surface of the substrate P, and, during stoppage of the supply operation of the supply port 12, to reduce the prescribed space SP between the concave surface 2 and the substrate table 4T in comparison with during execution of the supply operation of the supply port 12.

After the liquid LQ has been suctioned by the suction port 22 while being supplied from the supply port 12 in a status in which the concave surface 2 and the substrate table 4T have been placed in opposition, the prescribed space SP between the concave surface 2 and the substrate table 4T has been filled with the liquid LQ, and the supply operation of the supply port 12 and the suction operation of the suction port 22 have been stopped, the substrate table 4T is moved in the XY direction, and the control apparatus 7 places the concave surface 2 and the surface of the substrate P in opposition. Then, the control apparatus 7 irradiates the exposure light EL onto the substrate P via the projection optical system PL that includes the final optical element LS 1, which has a concave surface 2, and the liquid LQ in a status in which the concave surface 2 and the surface of the substrate have been placed in opposition.

In addition, in the present embodiment as well, the control apparatus 7 is able to remove (capture) foreign matter such as bubbles or particles in the liquid LQ and to replace (exchange) the liquid LQ that fills the prescribed space SP by performing the liquid supply operation of the supply port 12 and the fluid (mainly the liquid LQ) suction (recovery) operation of the suction port 22 in parallel in a status in which the prescribed space SP has been filled with the liquid LQ while placing the concave surface 2 and the supply port 12 and suction port 22 in opposition.

<Fifth Embodiment>

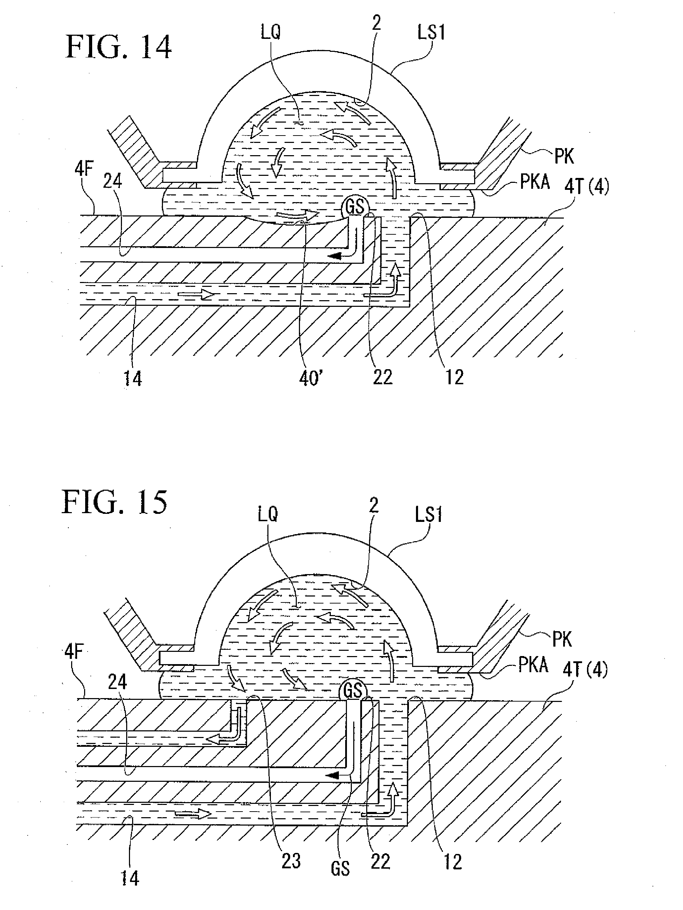

Next, a fifth embodiment will be explained while referring to FIG. 14. In the explanation below, identical codes are assigned to constituent portions that are identical or similar to those of the embodiments discussed above, and explanations thereof have been abbreviated or omitted. As shown in FIG. 14, the liquid immersion system 1 of the present embodiment, in the same way as the fourth embodiment discussed above, comprises a supply port 12 arranged at a prescribed position that opposes the peripheral part of the concave surface 2 of the final optical element LS 1 and a suction port 22 arranged between that supply port 12 and the optical axis AX of the final optical element LS1. In addition, a concave part 40' is provided at a portion of the upper surface 4F of the substrate table 4T. The concave part 40' is provided in the vicinity of the suction port 22. In the present embodiment, the concave part 40' is provided in the vicinity of the suction port 22 and at the side opposite the supply port 12 in relation to that suction port 22. The concave part 40' is provided at a position that can be placed in opposition with the concave surface 2 of the final optical element LS 1 when the supply port 12 has been arranged at a prescribed position that opposes the peripheral part of the concave surface 2 of the final optical element LS1.

In the present embodiment, the inner surface of the concave part 40' is a curved surface that sinks in so that it separates from final optical element LS1. Note that the inner surface of the concave part 40' may have a shape that combines plurality of flat surfaces that face mutually different directions for example.

The liquid LQ that has been sprayed out from a supply port 12 flows toward the upper surface 4F of the substrate table 4T so that it follows the concave surface 2 of the final optical element LS1, so there is a possibility that a vortex of the liquid LQ will be produced between the final optical element LS 1 and the substrate table 4T and the gas GS (bubbles) will remain in the center of that vortex, but in the present embodiment, the concave part 40' is provided, so even if a liquid LQ vortex were to be produced, it would be possible to form the center of that vortex in the vicinity of the upper surface 4F of the substrate table 4T (the vicinity of the suction port 22). Therefore, at times such as that of the initial filling operation, it is possible to quickly discharge the gas GS (bubbles) in the liquid LQ that fills the prescribed space SP via the suction port 22.

<Sixth Embodiment>

Next, a sixth embodiment will be explained while referring to FIG. 15. In the explanation below, identical codes are assigned to constituent portions that are identical or similar to those of the embodiments discussed above, and explanations thereof have been abbreviated or omitted. As shown in FIG. 15, the liquid immersion system 1 of the present embodiment, in the same way as the fourth embodiment discussed above, comprises a supply port 12 arranged at a prescribed position that opposes the peripheral part of the concave surface 2 of the final optical element LS 1 and a suction port 22 arranged between that supply port 12 and the optical axis AX of the final optical element LS 1. In addition, when the supply port 12 has been arranged at a prescribed position that opposes the peripheral part of the concave surface 2, a second suction port 23 is provided at the side opposite suction port 12 in relation to the optical axis AX of the final optical element LS1. The second suction port 23 is provided on the upper surface 4F of the substrate table 4T.

The control apparatus 7, at the time of the initial filling operation, by respectively adjusting the suction force of the suction port 22 (the fluid suction amount per unit time) and the suction force of the second suction port 23 while performing the supply operation of the supply port 12, the suction operation of suction port 22, and the suction operation of the second suction port 23 in parallel, is able to control the flow of the liquid LQ of the prescribed space SP, form a space where the pressure is low in the vicinity of the suction port 22, and collect the gas GS in the liquid LQ that fills the prescribed space SP in the vicinity of suction port 22. For example, through the suction operation of the second suction port 23, in the vicinity of suction port 22, it is possible to restrict the flow of the liquid LQ that moves from the bottom to top from being produced and to restrict the gas (bubbles, etc.) from moving so that it moves away from the suction port 22.

Note that, in the first to sixth embodiments discussed above, it is possible to use the suction port 22 in the case where the liquid LQ is completely removed (recovered) from the prescribed space SP of the light emittance surface side of the final optical element LS1. Specifically, by recovering the liquid LQ from the suction port 22 in a status in which the concave surface 2 of the final optical element LS 1 and the suction port 22 have been placed in opposition, it is possible to recover the liquid LQ of the prescribed space SP. At this time, it is possible to connect the supply port 12 to a vacuum apparatus (suction apparatus) to perform recovery of the liquid LQ of the prescribed space SP using both the supply port 12 and the suction port 22.

<Seventh Embodiment>

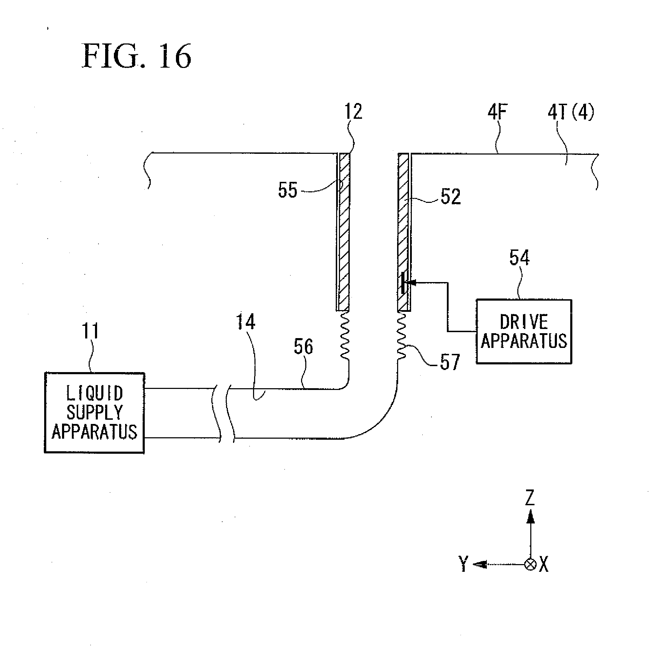

Next, a seventh embodiment will be explained while referring to FIG. 16. In the explanation below, identical codes are assigned to constituent portions that are identical or similar to those of the embodiments discussed above, and explanations thereof have been abbreviated or omitted. In FIG. 16, the liquid immersion system I comprises a supply member 52, which is provided on the substrate table 4T and has a supply port 12 that supplies the liquid LQ, and a drive apparatus 54 that moves the supply port 12 relative to the concave surface 2 by driving the supply member 52. The supply member 52 is a pipe-shaped member, and it is arranged at the inside of a hole 55 provided at a portion of the upper surface 4F of the substrate table 4T. The upper end of the supply member 52 is a supply port 12. The supply member 52 is able to move in the vertical direction (Z axis direction) by means of the driving force of the drive apparatus 54, and the supply port 12 moves back and forth with respect to the upper surface 4F of the substrate table 4T. In the present embodiment, when the supply member 52 descends and is arranged inside the hole 55, as shown in FIG. 16, the supply port 12 of the upper end of the supply member 52 becomes nearly flush with the upper surface 4F of the substrate table 4T. Note that the supply member 52 is able to move in the diagonal direction in relation to the Z axis direction.

In addition, the supply port 12 provided on the upper surface 4F of the substrate table 4T can be placed in opposition with the concave surface 2 of the final optical element LS1 by means of the movement of the substrate table 4T (substrate stage 4). On the other hand, the lower end of the supply member 52 is connected to the liquid supply apparatus 11 via a pipe member 56. In addition, an expansion mechanism 57 that is able to expand and contract is provided at a portion of the pipe member 56 so that it does not obstruct the movement of the supply member 52.

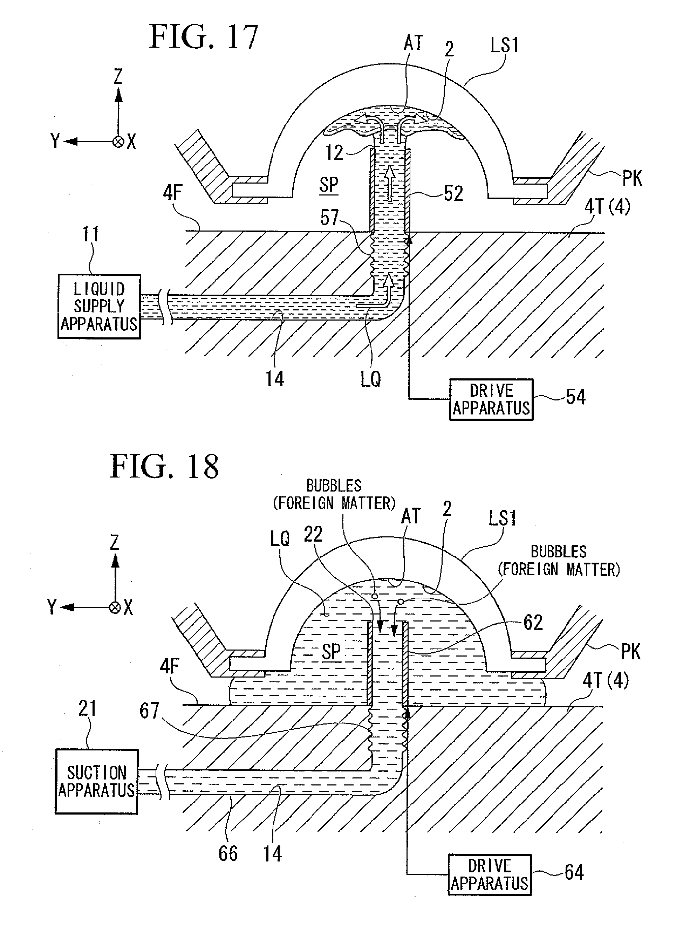

When the prescribed space SP initial filling operation is performed, the control apparatus 7 drives the substrate stage 4 and places the concave surface 2 of the final optical element LS1 and the supply port 12 on the substrate table 4T in opposition. Then, the control apparatus 7 uses a drive apparatus 54 to move (raise) the supply member 52 in the +Z direction and bring the supply port 12 provided on the upper end of the supply member 52 close to the concave surface 2. In addition, as shown in FIG. 17, the control apparatus 7 starts supply of the liquid LQ in a status in which the supply port 12 has been brought close to the concave surface 2 by a prescribed distance (for example, approximately 1 mm). In the present embodiment, the control apparatus 7 brings the apex position AT of the concave surface 2 and the supply port 12 close to each other. Then, the control apparatus 7 sprays out the liquid LQ from the supply port 12 while gradually moving (lowering) the supply member 52 in the -Z direction. By doing so, it is possible to fill the prescribed space SP between the concave surface 2 and the substrate table 4T with the liquid LQ well. In addition, after the prescribed space SP has been filled with the liquid LQ and the supply member 52 has been lowered until the supply port 12 and the upper surface 4F of the substrate table 4T have become nearly flush, the control apparatus 7 stops the supply of the liquid LQ while moving the substrate stage 4 in the XY direction to place the concave surface 2 and the surface of the substrate P in opposition and starts exposure of the substrate P.

At such times as during the initial filling operation, there is a strong possibility that the gas GS in the liquid LQ will remain at the top of the prescribed space SP (in the vicinity of the apex position AT of the concave surface 2). In the present embodiment, the liquid LQ is supplied in a status in which the supply port 12 has been brought close to the concave surface 2, so it is possible to restrict the gas GS from remaining at the top of the prescribed space SP (in the vicinity of the apex position AT of the concave surface 2).

Note that, in the seventh embodiment as well, a detection apparatus 30 may be provided to detect the presence or absence of the gas GS (including bubbles) of the prescribed space SP and control the liquid supply from the supply port 12 based on those detection results.

<Eighth Embodiment>

Next, an eighth embodiment will be explained while referring to FIG. 18. In the explanation below, identical codes are assigned to constituent portions that are identical or similar to those of the embodiments discussed above, and explanations thereof have been abbreviated or omitted. In FIG. 18, the liquid immersion system 1 comprises a suction member 62, which is provided on the substrate table 4T and has a suction port 22 that suctions the fluid, and a drive apparatus 64, which moves the suction port 22 relative to concave surface 2 by driving the suction member 62. The suction member 62 is a pipe-shaped member and is arranged inside a hole formed at a portion of the upper surface 4F of the substrate table 4T. The upper end of the suction member 62 is the suction port 22. The suction member 62 is able to move in the Z axis direction by means of the driving force of the drive apparatus 64, and the suction port 22 moves back and forth with respect to the upper surface 4F of the substrate table 4T. In the present embodiment, when the suction member 62 descends and is arranged inside the hole of the substrate table 4T, the suction port 22 of the upper end of the suction member 62 becomes nearly flush with the upper surface 4F of the substrate table 4T. Note that the suction member 62 is able to move in a diagonal direction in relation to the Z axis direction.

In addition, the supply port 22 provided on the upper surface 4F of the substrate table 4T can be placed in opposition with the concave surface 2 of the final optical element LS1 by means of the movement of the substrate table 4T (substrate stage 4). On the other hand, the lower end of the suction member 62 is connected to the suction apparatus 21 via a pipe member 66. In addition, an expansion mechanism 67 that is able to expand and contract is provided at a portion of the pipe member 66 so that it does not obstruct movement of the supply member 62.

As shown in FIG. 18, during the initial filling operation, there is a possibility that the gas GS will remain in the liquid LQ after the liquid LQ has been supplied to the prescribed space SP between the concave surface 2 and the substrate table 4T. There is a strong possibility that the gas GS, which has a lower specific gravity than the liquid LQ, will remain at the highest position (apex position) AT of the concave surface 2 or in the vicinity thereof.

For example, after the control apparatus 7 uses a supply member 52 such as that shown in FIG. 16 to supply the liquid LQ to the prescribed space SP between the concave surface 2 and substrate table 4T, it moves the substrate table 4T in the XY direction to place the supply member 52 and the suction port 22 of the suction member 62 provided at a separate position in opposition with the concave surface 2. Then, the control apparatus 7 moves (raises) the suction member 62 in the +Z direction to bring the suction port 22 provided on the upper end of the suction member 62 close to the concave surface 2. Specifically, the control apparatus 7 arranges the suction port 22 of the suction member 62 in the vicinity of the position where gas is present, that is, near the apex position AT of the concave surface 2. Then, the control apparatus 7 suctions and removes the gas GS that remains in the liquid LQ of the prescribed space SP in a status in which the suction port 22 has been brought close to the concave surface 2 by the prescribed distance (for example, approximately 1 mm).

Then, after the operation of the removal of the gas in the liquid LQ has been completed, that is, after the initial filling operation has been completed, the control apparatus 7 moves (lowers) the suction member 62 in the -Z direction. After the control apparatus 7 has lowered the suction member 62 until the suction port 22 and the upper surface 4F of the substrate table 4T become nearly flush, it moves the substrate stage 4 in the XY direction to place the concave surface 2 in opposition with the surface of the substrate P and starts exposure of the substrate P.

Note that, in the present embodiment, when the gas (including bubbles) GS that remains in the prescribed space SP at the time during operation is removed, a suction operation that uses the suction port 22 of the suction member 62 is executed, but even when foreign matter (including bubbles) that is present in the liquid LQ that fills the prescribed space SP is removed, it is possible to execute a suction operation that uses the suction port 22 of the suction member 62.

Note that, on the substrate table 4T, the suction port 22 of the suction member 62 may be arranged in the vicinity of the supply port 12 of the supply member 52 so that the supply port 12 of the supply member 52 and the suction port 22 of the suction member 62 can together be placed in opposition with the concave surface 2. Through this, it is possible to respectively execute the supply operation of the supply port 12 and the suction operation of the suction port 22 in a status in which the supply port 12 and the suction port 22 have been respectively brought close to the concave surface 2. In addition, it is also possible to perform exchange (replacement) of the liquid LQ of the prescribed space SP.

In addition, the suction member 62 (suction port 22) of the present embodiment may also be combined with the liquid immersion system 1 explained in the first to sixth embodiments discussed above.

<Ninth Embodiment>

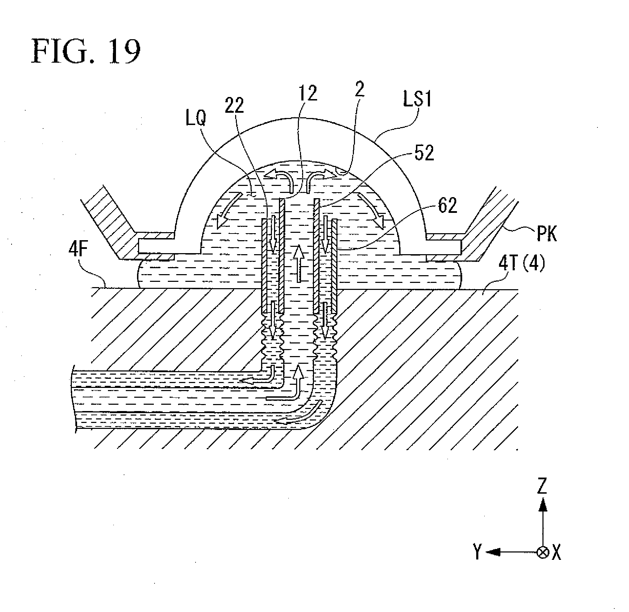

Next, a ninth embodiment will be explained while referring to FIG. 19. In the explanation below, identical codes are assigned to constituent portions that are identical or similar to those of the embodiments discussed above, and explanations thereof have been abbreviated or omitted. In FIG. 19, the liquid immersion system 1 comprises a supply member 52, which is provided on the substrate table 4T and has a supply port 12 that supplies the liquid LQ, and a suction member 62 that has a suction port 22 that suctions fluid. The suction member 62 is a pipe-shaped member arranged outside the supply member 52. Specifically, in the present embodiment, the supply member 52 and the suction member 62 are a double pipe. In addition, the supply member 52 and the suction member 62 are respectively able to move in the Z axis direction by means of a prescribed drive apparatus. In the present embodiment, the supply member 52 and the suction member 62 are able to mutually independently move.

In performing the initial filling operation, the control apparatus 7 respectively brings the supply port 12 of the supply member 52 and the suction port 22 of the suction member 62 close to the concave surface 2. Then, the control apparatus 7 executes a liquid supply operation that uses the supply port 12 and a suction operation that uses the suction port 22 in a status in which the supply port 12 and the suction port 22 have been respectively brought close to the concave surface 2. In the present embodiment, as shown in FIG. 19, the control apparatus 7 executes a liquid supply operation that uses the supply port 12 and a suction operation that uses the suction port 22 in a status in which the upper end of the suction member 52 is arranged closer to the concave surface 2 than the upper end of the suction member 62. Then, the control apparatus 7 executes a liquid supply operation that uses the supply port 12 and a suction operation that uses the suction port 22 while gradually moving (lowering) the supply member 52 and the suction member 62 respectively in the -Z direction. By doing so, it is possible to fill the prescribed space SP between the concave surface 2 and the substrate table 4T with the liquid LQ well. Then, after the prescribed space SP has been filled with the liquid LQ, and the supply member 52 and the suction member 62 have descended until the supply port 12 and the suction port 22 become nearly flush with the upper surface 4F of the substrate table 4T, the control apparatus 7 stops the supply operation of the supply port 12 and the suction operation of the suction port 22 while moving the substrate stage 4 in the XY direction to place the concave surface 2 in opposition with the surface of the substrate P and starts exposure of the substrate P.

Note that, in the present embodiment, the supply member 52 and the suction member 62 may be mutually independently moved, but the relative positional relationship between the supply member 52 and the suction member 62 may be fixed, and the supply member 52 and the suction member 62 may be moved together using a prescribed drive apparatus.

Note that, in the present embodiment, the operation of supply from the supply port 12 of the supply member 52 and the operation of suction from the suction port 22 of the suction member 62 are performed in parallel, but the operation of suction from the suction port 22 of the suction member 62 may be started in a status in which the liquid LQ is supplied from the supply port 12 of the supply member 52, and the prescribed space SP is nearly filled with the liquid LQ.

In addition, in the ninth embodiment as well, a detection apparatus 30 is provided to detect the presence or absence of the gas GS (bubbles) of the prescribed space SP to control the liquid supply from the supply port 12 based on those detection results.

In addition, in the present embodiment as well, it is possible to remove foreign matter such as bubbles or particles of the liquid LQ of the prescribed space SP by executing the supply operation of the supply port 12 and the suction operation of the suction port 22 in a status in which the prescribed space SP has been filled with the liquid LQ. In addition, it is also possible to replace (exchange) at least a portion of the liquid LQ of the prescribed space SP.

Note that, in the eighth and ninth embodiments, the suction port 22 of the suction member 62 may be used in the case where the liquid LQ is completely removed (recovered) from the prescribed space SP of the light emittance surface side of the final optical element LS1.

In addition, in the first to ninth embodiments discussed above, in the case where the liquid LQ is completely removed (recovered) from the prescribed space SP, the suction operation of the suction port 22 may be executed while the substrate table 4T is moved.

In addition, in the first to ninth embodiments discussed above, it is also possible to use a detection apparatus 30 that directly irradiates detection light to the prescribed SP for example to detect whether or not that prescribed space SP has been filled with the liquid LQ.

In addition, in the first to ninth embodiments discussed above, the detection apparatus 30 may also be omitted if it is possible to determine that the prescribed space SP has been filled with the liquid LQ by continuing the supply operation of the supply port 12 and/or the suction operation of the suction port 22 for a prescribed period of time.

<Tenth Embodiment>

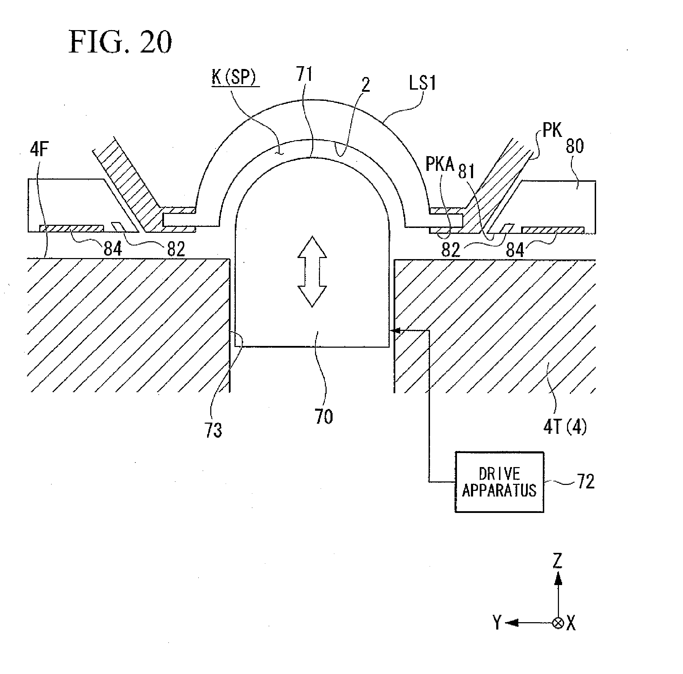

Next, a tenth embodiment will be explained while referring to FIG. 20. In the explanation below, identical codes are assigned to constituent portions that are identical or similar to those of the embodiments discussed above, and explanations thereof have been abbreviated or omitted. In FIG. 20, the exposure apparatus EX comprises a prescribed member 70, which is provided on the substrate table 4T and has a convex surface 71 that can be placed in opposition with the concave surface 2 of the final optical element LS1, and a drive apparatus 72 that moves the convex surface 71 relative to the concave surface 2 by means of the driving of the prescribed member 70. The convex surface 71 is a curved surface that follows the concave surface 2, and, in the present embodiment, it is formed in a spherical or aspheric shape.

The prescribed member 70 is arranged inside a hole 73 provided at a portion of the upper surface 4F of the substrate table 4T. The prescribed member 70 is able to move in the Z axis direction by means of the driving force of the drive apparatus 72 and is able to move back and forth with respect to the upper surface 4F of the substrate table 4T. Portions of the prescribed member 70 other than the convex surface 71 are formed in a cylindrical shape (columnar shape). In addition, in the vicinity of the convex surface 71 of the prescribed member 70, the upper surface 4F of the substrate table 4T is arranged so as to surround this convex surface 71.

The surface of the prescribed member 70, which includes the convex surface 71, has lyophilicity with respect to the liquid LQ. In the present embodiment, lyophilicity to the convex surface 71, etc. is provided by coating a film of a prescribed material that has lyophilicity with respect to liquid LQ onto the surface of the prescribed member 70, which includes the convex surface 71.

In addition, the exposure apparatus EX comprises a nozzle member 80 that has a supply port 82 that is able to supply the liquid LQ and a recovery port 84 that is able to recover the liquid LQ, which are provided so as to surround the final optical element LS 1 and the lens barrel PK. The nozzle member 80 has a lower surface 81, which is formed so as to surround the concave surface 2 of the final optical element LS1 and is placed in opposition with the upper surface 4F of the substrate table 4T. The lower surface 81 of the nozzle member 80 and the lower surface PKA of the lens barrel PK become nearly flush, and these lower surfaces PKA, 81 are arranged so as to surround the concave surface 2.

The respective supply port 82 and recovery port 84 are provided at the lower surface 81 of the nozzle member 80. In the present embodiment, the supply port 82 is respectively provided on the +Y side and the -Y side of the optical path K. In addition, in the present embodiment, the recovery port 84 is provided outside the supply port 82 with respect to the optical path K and is annularly formed so as to surround the optical path K. Note that it is possible to arrange a porous member or mesh member on the recovery port 84.

The supply port 82 is provided so that it is able to supply the liquid LQ between the lower surface PKA of the lens barrel PK and the upper surface 4F of the substrate table 4T that opposes that lower surface PKA.

In the present embodiment, the supply port 82 supplies the liquid LQ in the diagonal direction facing the optical path K so that it is able to supply the liquid LQ between the lower surface PKA of the lens barrel PK and the upper surface 4F of the substrate table 4T.

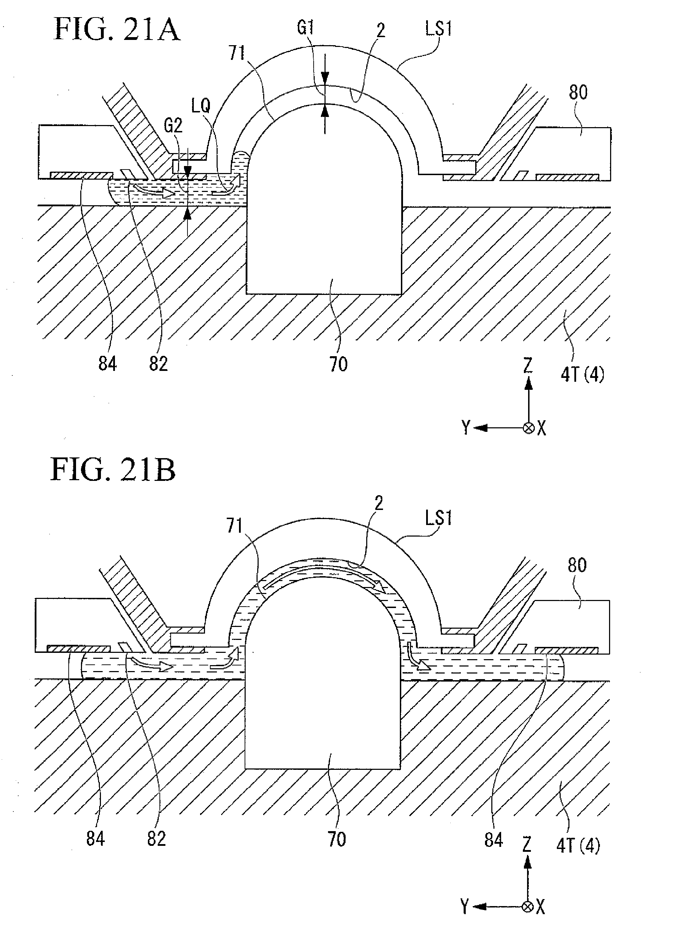

Next, the operation of the exposure apparatus EX, which includes the initial filling operation, will be explained. In executing the initial filling operation, the control apparatus 7 drives the substrate stage 4 in the XY direction to place the concave surface 2 of the final optical element LS1 and the convex surface 71 provided on the substrate table 4T in opposition. Then, the control apparatus 7 uses the drive apparatus 72 to move (raise) the prescribed member 70 in the +Z direction and bring the convex surface 71 of the prescribed member 70 close to the concave surface 2 of the final optical element LS 1. And, as shown in FIG. 21A, the control apparatus 7 starts the operation of the supply port 82 supplying the liquid LQ between the concave surface 2 and the convex surface 71 in a status in which the space between the concave surface 2 and the convex surface 71 has been set to a first distance G1 (approximately 0 .5 mm).

In addition, the control apparatus 7 starts recovery (suction) of the fluid (including the liquid LQ and the gas GS) by the recovery port 84. Specifically, the control apparatus 7 performs recovery (suction) by means of the recovery port 84 in parallel with the supply of the liquid LQ from a supply port 82.

As described above, the lower surface PKA (81) is formed so as to surround the concave surface 2, and the upper surface 4F of the substrate table 4T is formed so as to surround the convex surface 71. The supply port 82 fills the space between the concave surface 2 and the convex surface 71 with the liquid LQ by supplying the liquid LQ between the lower surface PKA and the upper surface 4F.

When the operation of supplying the liquid LQ between the concave surface 2 and the convex surface 71 is performed in a status in which the space between the concave surface 2 and the convex surface 71 has been set to a first distance G1, the space between the lower surface PKA of the lens barrel PK and the upper surface 4F of the substrate table 4T is set to a second distance G2 (approximately 1 mm). Here, the first distance G1 is smaller than the second distance G2. The control apparatus 7 sets the space between the concave surface 2 and the convex surface 71 to the first distance G1 while it starts the operation of supplying the liquid LQ to the space between the lower surface PKA and the upper surface 4F using the supply port 82 in a status in which the space between the lower surface PKA and the upper surface 4F has been set to the second distance G2.

In the present embodiment, in performing the initial filling operation, the liquid LQ is supplied from a prescribed location (one direction) from among the lower surface PKA and the upper surface 4F. For example, as shown in FIG. 21A, the control apparatus 7 supplies the liquid LQ from the supply port 82 arranged on the +Y side with respect to the optical path K. The liquid LQ that is supplied from the supply port 82 to the space between the lower surface PKA and the upper surface 4F flows into the space between the concave surface 2 and the convex surface 71 and expands to wet the space between the concave surface 2 and the convex surface 71.

In the present embodiment, the first distance G1 between the concave surface 2 and the convex surface 71 is smaller than the second distance G2 between the lower surface PKA and the upper surface 4F, and the liquid LQ that is supplied between the lower surface PKA and the upper surface 4F expands to wet the space between the concave surface 2 and the convex surface 71 by means of the capillary phenomenon, for example. Since the convex surface 71 has lyophilicity with respect to the liquid LQ, and the concave surface 2 also has lyophilicity with respect to the liquid LQ, the liquid LQ expands to wet the space between the concave surface 2 and the convex surface 71 well. Therefore, the liquid LQ that has flowed to the space between the concave surface 2 and the convex surface 71 can be caused closely adhere well to the concave surface 2 as shown in FIG. 21B.

The liquid LQ that has been supplied to the optical path K from the +Y side supply port 82 and has expanded to wet the space between the concave surface 2 and the convex surface 71 is ultimately recovered by a recovery port 84 arranged on the -Y side with respect to the optical path K. Since the operation of recovery of the fluid (the liquid LQ) by the recovery port 84 is executed in parallel with the liquid supply operation of the supply port 82, the liquid LQ is restricted from flowing to outside the recovery port 84.

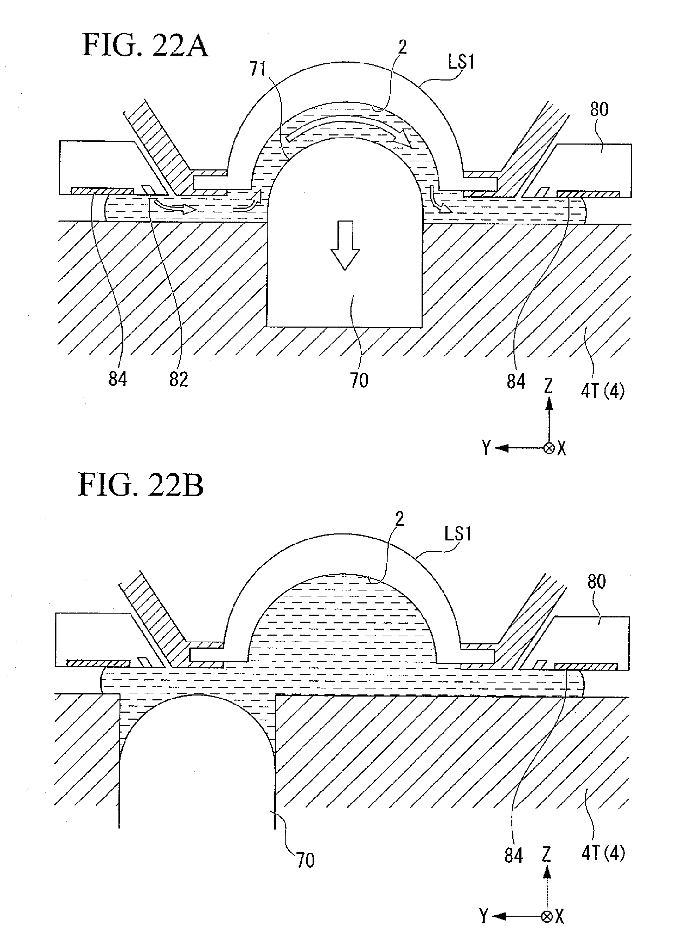

In addition, as shown in FIG. 22A, the control apparatus 7 performs the liquid supply operation of the supply port 82 and the liquid recovery operation of the recovery port 84 in parallel while gradually moving (lowering) the prescribed member 70 in the -Z direction. Specifically, the control apparatus 7 continues the liquid supply operation of the supply port 82 and the liquid recovery operation of the recovery port 84 while gradually increasing the distance between the concave surface 2 and the convex surface 71. The control apparatus 7 performs the supply operation of the supply port 82 respectively provided on the +Y side and the -Y side with respect to the optical path K and the recovery operation of the recovery port 84 in parallel. By doing so, it is possible to restrict outflow of the liquid LQ to outside the recovery port 84 while smoothly filling the space between the concave surface 2 and the convex surface 71 with the liquid LQ

In addition, as shown in FIG. 22B, after the prescribed space SP has been filled with the liquid LQ and the prescribed member 70 has been lowered until the upper end of the convex surface 71 becomes nearly the same height as the upper surface 4F of the substrate table 4T, the control apparatus 7 moves the substrate stage 4 in the XY direction to place the concave surface 2 and the surface of the substrate P in opposition and starts exposure of the substrate P.

In the present embodiment, the control apparatus 7 performs the supply operation of the supply port 82 and the recovery operation of the recovery port 84 in parallel even when the initial filling operation is ended and the substrate P is exposed.

As explained above, in the initial filling operation, the convex surface 71 is arranged at a position that opposes the concave surface 2, and the liquid LQ is supplied to the space between that concave surface 2 and the convex surface 71, so the liquid LQ is filled well up to the top of the prescribed space SP (the vicinity of the apex position AT).

Note that, in the present embodiment, the liquid LQ that has been supplied from the supply port 82 of the nozzle member 80 fills the space between the concave surface 2 and the convex surface 71, but it may also be such that the liquid LQ supplied from the supply port 12 provided on the upper surface of the substrate table 4T is used to fill the space between the concave surface 2 and the convex surface 71. In addition, a supply port may be provided on the convex surface 71 of the prescribed member 70, and the liquid supplied from the supply port of the convex surface 71 may be used to fill the space between the concave surface 2 and the convex surface 71.

Note that the nozzle member 80 of the present embodiment may be used together with the liquid immersion system 1 of the first to ninth embodiments discussed above.

<Eleventh Embodiment>

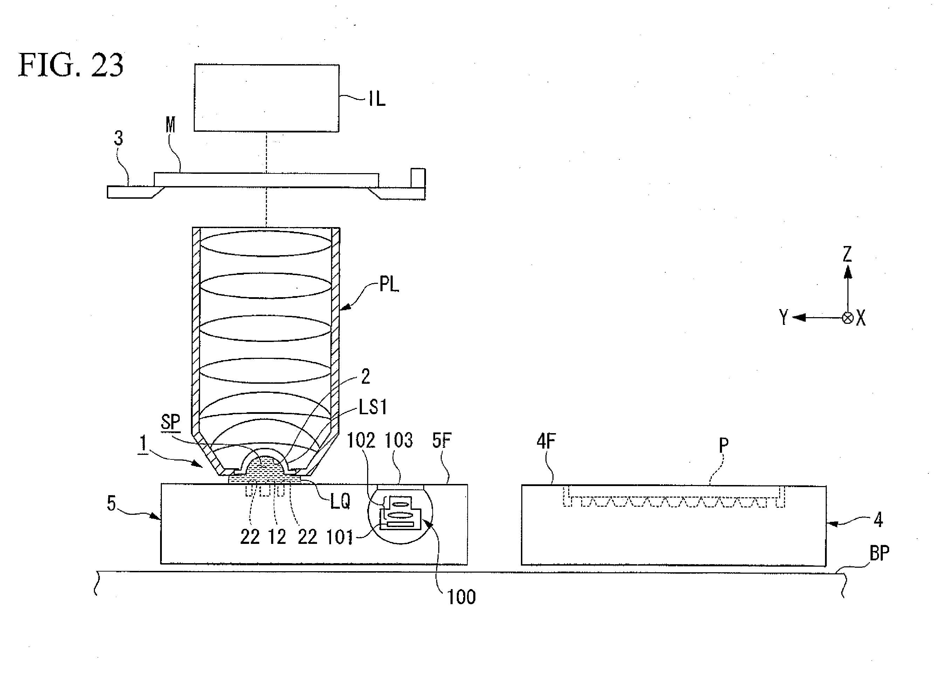

Next, an eleventh embodiment will be explained while referring to FIG. 23. In the explanation below, identical codes are assigned to constituent portions that are identical or similar to those of the embodiments discussed above, and explanations thereof have been abbreviated or omitted. In FIG. 23, a supply port 12 and a suction port 22 for filling the prescribed space SP explained in any of the first to ninth embodiments are provided on a measuring stage 5 that is able to move independently of the substrate stage 4. The measuring stage 5 has a built-in measuring apparatus relating to exposure processing and is able to move on a base member BP. Note that an exposure apparatus equipped with a measuring stage is disclosed in detail in, for example, Japanese Unexamined Patent Application Publication No. H11-135400 and Japanese Unexamined Patent Application Publication No. 2000-164504 (corresponds to U.S. Patent No. 6,897,963).

In addition, in the present embodiment, an observation camera 100 that is able to observe the status of the liquid LQ that fills the prescribed space SP is provided on the measuring stage 5. The observation camera 100 is arranged in the interior space of the measuring stage 5. An opening that connects to the interior space is formed on the upper surface 5F of the measuring stage 5, and a transparent member 103 made of quartz, etc. is arranged in that opening. The upper surface of the transparent member 103 is flat, and it forms a portion of the upper surface 5F of the measuring stage 5. The observation camera 100 is able to observe the status of the liquid LQ of the liquid immersion region LR formed on the upper surface 5 of the measuring stage 5 that includes the upper surface of the transparent member 103, that is, the status of the liquid LQ that fills the prescribed space SP, via the transparent member 103. The observation camera 100 comprises an optical system 102 and an image pickup element 101 formed by a CCD (charge coupled device), etc. The image pickup element 101 is able to obtain an image (optical image) such as that of the liquid LQ and the final optical element LS1 via the transparent member 103 and the optical system 102. The image pickup element 101 outputs the obtained image information to the control apparatus 7. The control apparatus 7 is able to obtain the status of the liquid LQ that fills the prescribed space SP based on the image pickup results of the observation camera 100.

In the present embodiment, the control apparatus 7 detects the presence or absence of the gas (including bubbles) GS in the liquid LQ that fills the space between the concave surface 2 of the final optical element LS1 and the upper surface 5F of the measuring stage 5 using the observation camera 100. Specifically, the control apparatus 7 moves the measuring stage 5 in the XY direction to place the concave surface 2 and the transparent member 103 in opposition after using the supply port 12 and the suction port 22 to perform the operation of initial filling of the prescribed space SP. Through this, the liquid immersion region LR is formed on the transparent member 103. The observation camera 100 obtains the image of the liquid LQ of the liquid immersion region LR via the transparent member 103. The control apparatus 7 is able to determine whether or not the gas (bubbles) GS is present in the liquid LQ that fills the prescribed space SP based on the output of the observation camera 100.

The control apparatus 7, in the case where it has been determined that the gas (bubbles) GS is present in the liquid LQ that fills the prescribed space SP based on the output of the observation camera 100, moves the measuring stage 5 in the XY direction to place the concave surface 2 and the suction port 22 on the measuring stage 5 in opposition and, for example, performs the prescribed processing for eliminating the gas portion in the liquid LQ. Then, after that processing has been executed, the concave surface 2 and the transparent member 103 are again placed in opposition, and the status of the liquid LQ that fills the prescribed space SP is observed using the observation camera 100.

The control apparatus 7, in the case where it has been determined that the gas (bubbles) GS is not present in the liquid LQ of the prescribed space SP based on the output of the observation camera 100, moves the liquid immersion region LR onto the substrate P to place the concave surface 2 and the substrate P on the substrate stage 4 in opposition.

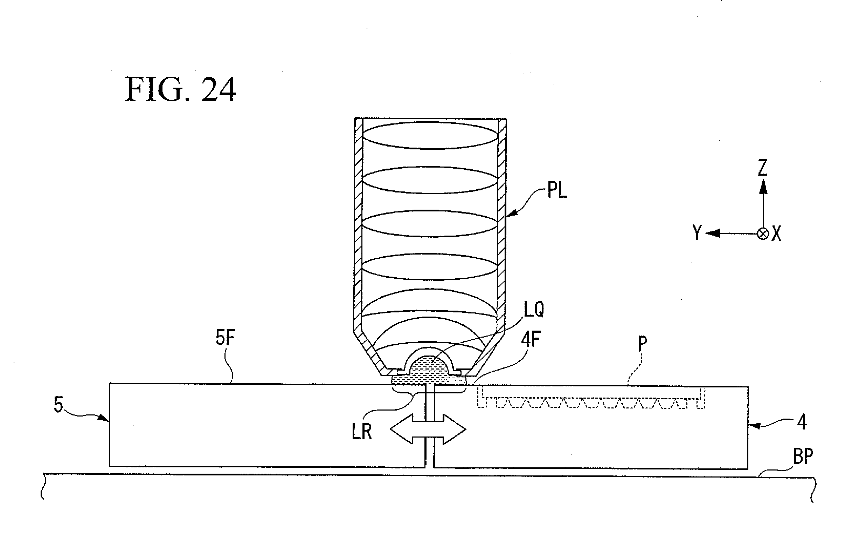

As shown in FIG. 24, the control apparatus 7 is able to move the liquid immersion region LR between the upper surface 4F of the substrate stage and the upper surface 5F of the measuring stage 5 by moving the substrate stage 4 and the measuring stage 5 together in the XY direction in a status in which the upper surface 4F of the substrate stage 4 and the upper surface 5F of the measuring stage 5 have been brought close to each other or come into contact within a prescribed region that includes a position directly below the projection optical system PL. Therefore, after the initial filling operation has been performed on the measuring stage 5, it is possible to move the liquid immersion region LR onto the substrate P held on the substrate stage 4 by executing an operation such as that shown in FIG. 24. Then, after the liquid LQ of the liquid immersion region LR has been moved onto the substrate P, the control apparatus 7 starts exposure of the substrate P via the projection optical system PL and the liquid LQ.

Note that, in the present embodiment, the observation camera 100 is also able to detect foreign matter in the liquid LQ, and the control apparatus 7 executes the prescribed processing based on the detection results of the observation camera 100.

Note that the measuring stage 5 of the present embodiment may also be applied to the tenth embodiment discussed above. In this case, it is possible to provide the prescribed member 70 on the measuring stage 5.

Note that, in the respective embodiments discussed above, the interface LG that forms the liquid immersion region LR is formed between the lower surface PKA of the lens barrel PK formed so as to surround the concave surface 2 and the objects (substrate, substrate stage, measuring stage) that oppose that lower surface PKA, but in the case where, for example, a portion (for example, the flange surface) of the final optical element LS 1 of the projection optical system PL is provided at the position nearest the upper surface 4F of the substrate table 4T for example, the interface LG of the liquid immersion region LR is formed between a portion of the final optical element LS 1 and the upper surface 4F of the substrate table 4T. In this case, in the tenth embodiment discussed above, since the supply port supplies the liquid LQ between the concave surface 2 and the convex surface 71, it is possible to supply the liquid LQ between a portion (flange surface) of the final optical element LS1 and the upper surface 4F of the substrate table 4T.

Note that, in the respective embodiments discussed above, the optical path between optical element LS1 and optical element LS2 may also be filled with the liquid LQ. In this case, the liquid that fills the space between optical element LS 1 and optical element LS2 may be the same as the liquid LQ that fills the prescribed space SP discussed above, or it may be different, and the refractive index may be smaller than that of the liquid LQ that fills the prescribed space SP discussed above.

In addition, in the first to sixth embodiments discussed above, since a movable member (such as supply member 52, a suction member 62 or a prescribed member 70) such as that shown in the seventh to tenth embodiments is not provided on the object (for example, the substrate table 4T) placed in opposition with the final optical element LS1, it is possible to fill the space between the concave surface 2 of the final optical element LS1 and the object (for example, the substrate table 4T) with the liquid LQ without generating foreign matter such as particles.

In addition, in the respective embodiments discussed above, an ArF excimer laser is used as the exposure light EL, but, as discussed above, it is possible to employ various exposure lights (exposure beams) such as an $F_2$ laser, and, for the liquid LQ that fills the optical path K, one that is optimal according to the exposure light (exposure beam) EL, the numerical aperture of the projection optical system PL, and the refractive index of the final optical element LS 1 with respect to the exposure light EL may be appropriately used.

Note that, in the respective embodiments above, an interferometer system (3L, 4L) was used to measure the respective position information of the mask stage 3 and the substrate stage 4, but it is not limited to this, and an encoder system that detects the scale (diffraction grating) provided on the respective stages, for example, may be used. In this case, it is preferable that a hybrid system comprising both an interferometer system and an encoder system be used and that calibration of the measurement results of the encoder system be performed using measurement results of the interferometer system. In addition, it may be such that positional control of the stage is performed by switching between usage of an interferometer system and an encoder system or by using both.

Note that applied as the substrate P of the respective embodiments above are not only semiconductor wafers for the fabrication of semiconductor devices but glass substrates for display devices, ceramic wafers for thin-film magnetic heads, base plates of mask or reticles used in exposure apparatuses (synthetic quartz, silicon wafers), etc.

Applicable as the exposure apparatus EX are, in addition to step and scan system scanning exposure apparatuses (scanning steppers) that synchronously move the mask M and the substrate P to scan expose the pattern of the mask M, step and repeat system projection exposure apparatuses (steppers) that full-field expose the pattern of the mask M in a status in which the mask M and the substrate P have been made stationary and sequentially step move the substrate P.

In addition, for the exposure apparatus EX, also possible is application to an exposure apparatus of a system that full-field exposes a reduced image of the first pattern onto the substrate P using a projection optical system (for example, a refracting type projection optical system that does not include a reflecting element, at a 1/8 reduction magnification ratio) in a status in which the first pattern and the substrate P have been made nearly stationary. In this case, after this, also possible is application to a stitch system full field exposure apparatus that full-field exposes the reduced image of the second pattern onto a substrate P to be partially superposed with the first pattern using that projection optical system in a status in which the second pattern and the substrate P have been made nearly stationary. In addition, for the stitch system exposure apparatus, also possible is application to a step and stitch system exposure apparatus that partially superposes and transfers at least two patterns on the substrate P and sequentially moves the substrate P.

In addition, in the above respective embodiments, the examples explained were of exposure apparatuses comprising a projection optical system PL, but the present invention may also be applied to exposure apparatuses and exposure methods that do not use a projection optical system PL. Even in the case in which a projection optical system is not used, exposure light is irradiated to a substrate via an optical member such as a mask or lens, and a liquid immersion region is formed in the prescribed space between such an optical member and the substrate.

In addition, the present invention can also be applied to a multi-stage type exposure apparatus comprising a plurality of substrate stages such as those disclosed in, for example, Japanese Unexamined Patent Application Publication No. 10-163099, Japanese Unexamined Patent Application Publication No. 10-214783 (corresponds to U.S. Patent No. 6,590,634), Published Japanese Translation No. 2000-505958 of PCT International Application (corresponds to U.S. Patent No. 5,969,441) and U.S. Patent No. 6,208,407. In this case, a liquid immersion system 1 discussed above may be provided for all of the stages or may be provided for some of the stages.

The types of exposure apparatuses EX are not limited to exposure apparatuses for semiconductor device fabrication that expose a semiconductor device pattern onto a substrate P but are also widely applicable to exposure apparatuses for the manufacture of liquid crystal display elements and for the manufacture of displays, and exposure apparatuses for the manufacture of thin film magnetic heads, image pickup elements (CCDs), micro machines, MEMS, DNA chips or reticles or masks.

Note that, in the above respective embodiments, a light transmitting type mask in which a prescribed light shielding pattern (or phase pattern / light reduction pattern) has been formed on a light transmissive substrate is used, but, instead of this mask, an electronic mask (includes, for example, a DMD (digital micromirror device), also called a variable shape mask, for example, a type of non-light transmissive image display element (spatial light modulator)) that forms a transmission pattern or a reflection pattern or a light emission pattern based on electronic data of the pattern to be exposed may be used as disclosed in U.S. Patent No. 6,778,257.

In addition, it is also possible to apply the present invention to an exposure apparatus (lithography system) that exposes a line and space pattern onto a substrate P by forming interference fringes on the substrate P as disclosed in the International Publication No. 2001/035168 pamphlet.

In addition, it is also possible to apply the present invention to an exposure apparatus that synthesizes two mask patterns on a substrate via a projection optical system and nearly synchronously double exposes one-shot region on the substrate by means of a single scanning exposure as disclosed in, for example, Published Japanese Translation No. 2004-519850 of PCT International Application (corresponds to U.S. Patent No. 6,611,316).

Note that, insofar as it is permitted by law, the disclosures of all publications and the disclosures of U.S. patents relating to exposure apparatuses, etc. cited in the above respective embodiments and modification examples will be invoked and be made part of the description of this text.

In the above way, the exposure apparatus EX of the present embodiment is manufactured by assembling various subsystems, including the respective constituent elements presented in the Scope of Patents Claims, so that the prescribed mechanical precision, electrical precision and optical precision are maintained. To ensure these respective precisions, performed before and after this assembly are adjustments for achieving optical precision with respect to the various optical systems, adjustments for achieving mechanical precision with respect to the various mechanical systems, and adjustments for achieving electrical precision with respect to the various electrical systems. The process of assembly from the various subsystems to the exposure apparatus includes mechanical connections, electrical circuit wiring connections, air pressure circuit piping connections, etc. among the various subsystems. Obviously, before the process of assembly from these various subsystems to the exposure apparatus, there are the processes of individual assembly of the respective subsystems. When the process of assembly of the various subsystems into the exposure apparatus has ended, overall adjustment is performed, and the various precisions are ensured for the exposure apparatus as a whole. Note that it is preferable that the manufacture of the exposure apparatus be performed in a clean room in which the temperature, the degree of cleanliness, etc. are controlled.

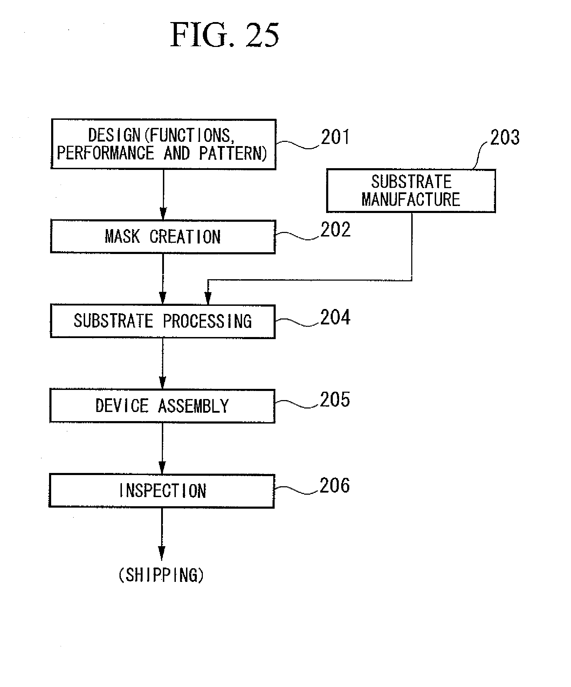

As shown in Fig. 25, microdevices such as semiconductor devices are manufactured by going through a step 201 that performs microdevice function and performance design, a step 202 that creates a mask (reticle) based on this design step, a step 203 that manufactures a substrate that is the device base material, a step 204 that includes substrate processing processes such as a process that exposes the pattern of the mask on the substrate by means of an exposure apparatus EX of an embodiment discussed above, a process that develops the exposed substrate, and processes for heating (curing) and etching the developed substrate, a device assembly step (including a dicing process, a bonding process and a packaging process) 205, and an inspection step 206, etc.

## Claims

1. An exposure apparatus that irradiates exposure light onto a substrate to expose the substrate, comprising:

   an optical element that has a concave surface from which the exposure light is emitted;
   a supply port that is provided on an object and that can be placed in opposition with the concave surface and supplies liquid to a space between the concave surface and the object; and
   a suction port that is provided on the object and suctions fluid between the concave surface and the object.

2. An exposure apparatus according to Claim 1, wherein the suction port suctions the fluid between the concave surface and the object in parallel with the supply of the liquid via the supply port.

3. An exposure apparatus according to Claim 2, wherein the fluid includes gas.

4. An exposure apparatus according to Claim 3, wherein the suction port is arranged at a position where the gas in the space collects.

5. An exposure apparatus according to any one of Claims 1 to 4, wherein the suction port is arranged in the vicinity of the supply port.

6. An exposure apparatus according to any one of Claims 1 to 5, wherein, during the supply of the liquid, the supply port is arranged on the optical axis of the optical element.

7. An exposure apparatus according to Claim 6, wherein the suction port is provided so as to surround the supply port.

8. An exposure apparatus according to any one of Claims 1 to 5, wherein, during the supply of the liquid, the supply port is arranged in opposition to the peripheral part of the concave surface.

9. An exposure apparatus according to Claim 8, wherein the suction port is arranged between the supply port and the optical axis of the optical element.

**10.** An exposure apparatus according to Claim 8, wherein

the suction port comprises:

a first suction port arranged between the supply port and the optical axis of the optical element; and
a second suction port arranged at the side opposite the supply port in relation to the optical axis.

**11.** An exposure apparatus according to any one of Claims 1 to 10, wherein the object has a concave part.

**12.** An exposure apparatus according to Claim 11, wherein the concave part is provided in the vicinity of the suction port.

**13.** An exposure apparatus according to any one of Claims 1 to 12, further comprising:

a first drive apparatus that moves the supply port relative to the concave surface.

**14.** An exposure apparatus according to Claim 13, wherein the first drive apparatus brings the supply port close to the concave surface.

**15.** An exposure apparatus according to any one of Claims 1 to 14, wherein the liquid strikes the concave surface via the supply port.

**16.** An exposure apparatus according to any one of Claims 1 to 15, further comprising:

a second drive apparatus that moves the suction port relative to the concave surface.

**17.** An exposure apparatus according to Claim 16, wherein the second drive apparatus brings the suction port close to the concave surface.

**18.** An exposure apparatus according to any one of Claims 1 to 17, further comprising:

a detection apparatus that detects the gas in the liquid in the space; and
a control apparatus that controls at least one of the supply of the liquid and the suction of the fluid based on the detection results.

**19.** An exposure apparatus according to any one of Claims 1 to 18, wherein the supply of the liquid and the suction of the fluid stop after the space is filled with the liquid, the concave surface and the surface of the substrate are placed in opposition, and the exposure light is irradiated onto the substrate via the optical element and the liquid.

**20.** An exposure apparatus according to Claim 19, wherein, during execution of the supply of the liquid, the positional relationship between the concave surface and the object is adjusted so that the space between the concave surface and the object becomes larger compared with during stoppage of the supply of the liquid.

**21.** An exposure apparatus according to any one of Claims 1 to 20, wherein
the object includes a convex surface that can be placed in opposition with the concave surface, and
the supply of the liquid to the space between the concave surface and the convex surface is continued while the distance between the concave surface and the convex surface is made larger.

**22.** An exposure apparatus that irradiates exposure light onto a substrate to expose the substrate, comprising:

an optical element that has a concave surface from which the exposure light is emitted;
an object that includes a convex surface; and
a supply port that supplies the liquid to a space between the concave surface and the convex surface in a status in which the concave surface and the convex surface have been placed in opposition.

**23.** An exposure apparatus according to Claim 22, wherein the operation of supplying the liquid to the space between the concave surface and the convex surface is continued while the distance between the concave surface and the convex surface is made larger.

**24.** An exposure apparatus according to Claim 22 or 23, further comprising:

a first surface formed so as to surround the concave surface; and
a second surface formed on the object so as to surround the convex surface, wherein
the supply port supplies the liquid to the space between the concave surface and the convex surface by supplying the liquid to a space between the first surface and second surface.

**25.** An exposure apparatus according to Claim 24, wherein
the supply of the liquid to the space between first surface and the second surface is started in a status in which the space between the concave surface and the convex surface is set to a first distance while the space between the first surface and the second surface is set to a second distance, and

the first distance is smaller than the second distance.

26. An exposure apparatus according to Claim 24 or 25, further comprising:

a recovery port that is provided at a separate position from the supply port and recovers the liquid between the first surface and the second surface.

27. An exposure apparatus according to any one of Claims 21 to 26, wherein the convex surface has lyophilicity with respect to the liquid.

28. An exposure apparatus according to any one of Claims 1 to 27, wherein the refractive index of the liquid with respect to the exposure light is higher than the refractive index of the optical element with respect to the exposure light.

29. An exposure apparatus according to any one of Claims 1 to 28, further comprising:

a projection optical system that projects a pattern image onto the substrate, wherein the optical element is an optical element nearest the image plane of the projection optical system, from among the plurality of optical elements of the projection optical system, and the numerical aperture of the projection optical system is larger than refractive index of the optical element with respect to the exposure light.

30. An exposure apparatus according to any one of Claims 1 to 29, wherein the object is able to move in a two-dimensional direction within a prescribed region that includes a position that opposes the concave surface.

31. An exposure apparatus according to Claim 30, wherein the object includes at least one of a first movable member, which holds the substrate and is able to move, and a second movable member, which has a built-in measuring apparatus that performs measurement relating to exposure processing and is able to move.

32. An exposure method that irradiates exposure light onto a substrate via an optical element to expose the substrate, the method comprising:

supplying a liquid via a supply port provided on an object that can be placed in opposition with a concave surface of the optical element to a space between the concave surface and the object; and suctioning fluid between the concave surface and the object via a suction port provided on the object.

33. An exposure method according to Claim 32, wherein the fluid is suctioned in parallel with supply of the liquid.

34. An exposure method according to Claim 32 or 33, wherein the fluid includes gas.

35. An exposure method according to Claim 34, wherein the gas is suctioned from the vicinity of the position where the gas in the space collects.

36. An exposure method according to any one of Claims 32 to 34, wherein the fluid is suctioned from the vicinity of the supply port.

37. An exposure method according to any one of Claims 32 to 36, wherein the fluid is supplied via the supply port arranged on the optical axis of the optical element.

38. An exposure method according to Claim 37, wherein the fluid is suctioned via the suction port arranged so as to surround the supply port.

39. An exposure method according to any one of Claims 32 to 3 8, wherein the liquid strikes the concave surface via the supply port.

40. An exposure method according to any one of Claims 32 to 39, wherein the liquid is supplied in a status in which the supply port has been brought close to the concave surface.

41. An exposure method according to any one of Claims 32 to 40, wherein the fluid is suctioned in a status in which suction port has been brought close to the concave surface.

42. An exposure method according to any one of Claims 32 to 36, wherein the fluid flows along the concave surface from the peripheral part of the concave surface.

43. An exposure method according to any one of Claims 32 to 42, wherein the supply of the liquid and the suction of the fluid are stopped after the space has been filled with the liquid, the concave surface is placed in opposition with the surface of the substrate, and the exposure light is irradiated onto the substrate via the optical element and the liquid.

44. An exposure method according to Claim 43, wherein the positional relationship between the concave surface and the object is adjusted so that the space between the concave surface and the object becomes larger during execution of the supply operation of the supply port than during stoppage of the supply operation of the supply port.

**45.** An exposure method according to any one of Claims 32 to 44, wherein, in a status in which the concave surface and the convex surface of the object have been placed in opposition, the supply operation that supplies the liquid to the space between the concave surface and the convex surface is continued while making the distance between the concave surface and the convex surface larger.

**46.** An exposure method that irradiates exposure light onto a substrate via an optical element to expose the substrate, the method comprising:

arranging an object in opposition with a concave surface of the optical element; and
supplying a liquid to a space between the concave surface and the object, the liquid flowing along the concave surface.

**47.** An exposure method that irradiates exposure light onto a substrate via an optical element to expose the substrate, the method comprising:

arranging an object in opposition with a concave surface of the optical element; and
supplying a liquid to a space between the concave surface and the object, wherein
the supply of the liquid is performed from the concave surface side with respect to the object.

**48.** An exposure method according to Claim 46 or 47, wherein the liquid flows along the concave surface at the start of supply of the liquid.

**49.** An exposure method according to any one of Claims 46 to 48, wherein supply of the liquid is performed in a status in which the supply port that supplies the liquid has been brought close to the concave surface.

**50.** An exposure method according to any one of Claims 46 to 49, wherein the liquid strikes the concave surface via the supply port.

**51.** An exposure method according to Claim 46 or 47, wherein the liquid flows along the concave surface from the peripheral part of the concave surface.

**52.** An exposure method according to any one of Claims 46 to 51, wherein the supply of the liquid to the space is continued while varying the interval of the concave surface and the object.

**53.** An exposure method according to Claim 46 or 47, wherein the liquid is supplied to the space between the concave surface and the convex surface in a status in which the concave surface and the convex surface of the object have been placed in opposition.

**54.** An exposure method according to Claim 53, wherein the supply of the liquid to the space between the concave surface and the convex surface is continued while increasing the distance between the concave surface and the convex surface.

**55.** An exposure method according to Claim 53 or 54, wherein the liquid is supplied to the space between the concave surface and the convex surface by supplying the liquid to the space between a first surface formed so as to surround the concave surface and a second surface formed on the object so as to surround the convex surface.

**56.** An exposure method according to Claim 55, wherein the liquid between the first surface and the second surface is collected via a recovery port arranged in opposition with the object.

**57.** An exposure method according to any one of Claims 46 to 56, wherein the liquid is supplied via a supply port provided on the object.

**58.** An exposure method that irradiates exposure light onto a substrate via an optical element to expose the substrate, the method comprising:

arranging an object in opposition with a concave surface of the optical element and
supplying a liquid to a space between the concave surface and the object, a liquid supply path used when the liquid is filled into the space being different from a liquid supply path used at the time of the exposure of the substrate.

**59.** An exposure method according to Claim 58, wherein the space is filled with the liquid via a supply port provided on the object.

**60.** An exposure method according to Claim 58 or 59, wherein the liquid is supplied at the time of the exposure via a supply port that has been arranged in opposition with the object.

**61.** An exposure method according to any one of Claims 58 to 60, wherein the liquid is supplied at the time of the exposure via a supply port arranged on a first surface formed so as to surround the concave surface.

**62.** An exposure method according to Claim 61, wherein the liquid is supplied to the space between the first surface and a second surface formed on the object via a supply port arranged on the first surface.

**63.** An exposure method that irradiates exposure light onto a substrate via an optical element to expose the substrate, the method comprising:

supplying a liquid to a space between a light emittance surface of the optical element and an object; and

changing the interval of the optical element and the object in the time from the start of the supply of the liquid until the space is filled with the liquid.

**64.** An exposure method according to Claim 63, wherein the light emittance surface of the optical element is a concave surface.

**65.** An exposure method according to Claim 64, wherein the liquid is supplied to the space between the concave surface and the convex surface in a status in which the concave surface and the convex surface of the object have been placed in opposition.

**66.** An exposure method according to Claim 65, wherein the supply of the liquid to the space between the concave surface and the convex surface is continued while increasing the distance between the concave surface and the convex surface.

**67.** An exposure method according to Claim 63, wherein the supply of the liquid is performed in a status in which the supply port that supplies the liquid has been brought close to the concave surface.

**68.** An exposure method according to any one of Claims 32 to 67, wherein the refractive index of the liquid with respect to the exposure light is higher than the refractive index of the optical element with respect to the exposure light.

**69.** An exposure method according to any one of Claims 32 to 68, wherein
the optical element is an optical element of the projection optical system that projects the pattern image onto the substrate that is nearest the image plane, and
the numerical aperture of the projection optical system is larger than the refractive index of the optical element with respect to the exposure light.

**70.** A device manufacturing method that uses the exposure method according to any one of Claims 32 to 69.

FIG. 1

## FIG. 2A

## FIG. 2B

FIG. 3

FIG. 4A

FIG. 4B

## FIG. 5A

## FIG. 5B

# FIG. 6

EP 1 950 795 A1

# FIG. 7

FIG. 8A

FIG. 8B

FIG. 9

FIG. 10

FIG. 11A

FIG. 11B

## FIG. 12A

## FIG. 12B

## FIG. 13A

## FIG. 13B

FIG. 14

FIG. 15

FIG. 16

FIG. 17

FIG. 18

# FIG. 19

FIG. 20

## FIG. 21A

## FIG. 21B

FIG. 22A

FIG. 22B

FIG. 23

EP 1 950 795 A1

EP 1 950 795 A1

FIG. 24

# FIG. 25

```
┌──────────────────────────┐
│   DESIGN (FUNCTIONS,      │──201          ┌203
│ PERFORMANCE AND PATTERN)  │               │
└──────────────────────────┘        ┌──────────────────┐
            │                        │   SUBSTRATE      │
            ▼                        │  MANUFACTURE     │
┌──────────────────────────┐        └──────────────────┘
│     MASK CREATION         │──202            │
└──────────────────────────┘                 │
            │                                 │
            ▼              ┌──────────────────┘
┌──────────────────────────┐
│   SUBSTRATE PROCESSING    │──204
└──────────────────────────┘
            │
            ▼
┌──────────────────────────┐
│     DEVICE ASSEMBLY       │──205
└──────────────────────────┘
            │
            ▼
┌──────────────────────────┐
│       INSPECTION          │──206
└──────────────────────────┘
            │
            ▼
        (SHIPPING)
```

<div align="center">**INTERNATIONAL SEARCH REPORT**</div>

| International application No. |
| --- |
| PCT/JP2006/321751 |

A.  CLASSIFICATION OF SUBJECT MATTER
*H01L21/027*(2006.01)i, *G03F7/20*(2006.01)i

According to International Patent Classification (IPC) or to both national classification and IPC

B.  FIELDS SEARCHED

Minimum documentation searched (classification system followed by classification symbols)
H01L21/027, G03F7/20

Documentation searched other than minimum documentation to the extent that such documents are included in the fields searched
Jitsuyo Shinan Koho          1922-1996     Jitsuyo Shinan Toroku Koho     1996-2006
Kokai Jitsuyo Shinan Koho     1971-2006     Toroku Jitsuyo Shinan Koho     1994-2006

Electronic data base consulted during the international search (name of data base and, where practicable, search terms used)

C.  DOCUMENTS CONSIDERED TO BE RELEVANT

| Category* | Citation of document, with indication, where appropriate, of the relevant passages | Relevant to claim No. |
| --- | --- | --- |
| X | WO 2004/114380 A1  (Nikon Corp.), 29 December, 2004 (29.12.04), Full text (particularly, Par. Nos. [0134] to [0136]; Fig. 8) & EP 1635382 A1        & US 2006/0114445 A1 & US 2006/0132740 A1     & US 2006/0132739 A1 | 22 |
| X Y A | WO 2004/055803 A1  (KONINKLIJKE PHILIPS ELECTRONICS N.V.), 01 July, 2004 (01.07.04), Full text; (particularly, Fig. 2) & EP 1573730 A1        & JP 2006-510146 A | 46-51 23-31,52-55, 58-62,64-66 1-21,32-45, 56,57 |

☒  Further documents are listed in the continuation of Box C.          ☐  See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered    to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search 15 December, 2006 (15.12.06) | Date of mailing of the international search report 26 December, 2006 (26.12.06) |
| --- | --- |
| Name and mailing address of the ISA/ Japanese Patent Office | Authorized officer |
| Facsimile No. | Telephone No. |

Form PCT/ISA/210 (second sheet) (April 2005)

| | **INTERNATIONAL SEARCH REPORT** | International application No. |
|---|---|---|
| | | PCT/JP2006/321751 |

C (Continuation).   DOCUMENTS CONSIDERED TO BE RELEVANT

| Category* | Citation of document, with indication, where appropriate, of the relevant passages | Relevant to claim No. |
|---|---|---|
| X<br>Y | JP 2005-191394 A  (Canon Inc.),<br>14 July, 2005 (14.07.05),<br>Full text (particularly, Par. Nos. [0004],<br>[0045], [0072])<br>& US 2005/0254026 A1 | 63,67-70<br>23-31,52-55,<br>64-66 |
| Y | WO 2004/102646 A1  (Nikon Corp.),<br>25 November, 2004 (25.11.04),<br>Full text (particularly, page 23, lines 3<br>to 17)<br>& EP 1624481 A1        & US 2006/0061747 A1<br>& US 2006/0152698 A1 | 58-62 |
| A | JP 2004-335746 A  (Nikon Corp.),<br>25 November, 2004 (25.11.04),<br>Full text (particularly, Fig. 2)<br>(Family: none) | 1-70 |
| P,A | JP 2006-222222 A  (Canon Inc.),<br>24 August, 2006 (24.08.06),<br>Full text (particularly, Fig. 9)<br>& US 2006/0176461 A1 | 1-70 |

Form PCT/ISA/210 (continuation of second sheet) (April 2005)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2005318139 A
- WO 9949504 A
- JP H8130179 B
- US 6721034 B
- JP 2001510577 W
- WO 199928790 A
- WO 2005059617 A
- WO 2005059618 A
- JP H11135400 B
- JP 2000164504 A
- US 6897963 B

- JP 10163099 A
- JP 10214783 A
- US 6590634 B
- JP 2000505958 W
- US 5969441 A
- US 6208407 B
- US 6778257 B
- US 2001035168 A
- JP 2004519850 W
- US 6611316 B